(19)

Europäisches Patentamt

European Patent Office

Office européen des brevets

(11) **EP 4 741 898 A1**

(12) **EUROPEAN PATENT APPLICATION**

(43) Date of publication:
**13.05.2026 Bulletin 2026/20**

(21) Application number: **25199784.7**

(22) Date of filing: **02.09.2025**

(51) International Patent Classification (IPC):
**G02B 6/42** (2006.01) **G06F 1/20** (2006.01)
**H05K 7/20** (2006.01)

(52) Cooperative Patent Classification (CPC):
**G02B 6/4269; G06F 1/20; G06F 1/203;**
G02B 6/4246; G02B 6/4261

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **08.11.2024 JP 2024195794**

(71) Applicant: **Japan Aviation Electronics Industry, Limited**
**Tokyo 150-0043 (JP)**

(72) Inventor: **HASHIGUCHI, Osamu**
**Tokyo, 150-0043 (JP)**

(74) Representative: **Vossius & Partner**
**Patentanwälte Rechtsanwälte mbB**
**Siebertstrasse 3**
**81675 München (DE)**

(54) **ELECTRONIC DEVICE**

(57) A heat sink (heat conductive sheet) is pressed against a plug shell without sliding on the plug shell. In an electronic device 10, a heat sink 51 is supported to be movable in a first direction and a second direction relative to a receptacle shell 61. First pressing means 63 pressing the heat sink 51 in a positive first direction relative to the receptacle shell 61, and second pressing means 64 pressing the heat sink 51 in a negative second direction relative to the receptacle shell 61 are disposed. The receptacle shell 61 includes a guide portion (cam groove 62). The heat sink 51 includes a guided portion (columnar protrusion 57) guided by the guide portion (cam groove 62). The heat sink 51 and a plug connector 20 respectively include abutting surfaces 55 and 25 abutting on each other in the first direction when the plug connector 20 is inserted into an opening 42 of a receptacle housing 41.

Fig. 1

## Description

BACKGROUND OF THE INVENTION

Field of the Invention

The present invention relates to an electronic device.

Description of the Related Art

An electronic device in recent years is required to have higher heat dissipation efficiency because power consumption of mounted electronic parts is increased along with demands such as for increase in communication speed and improvement in processing performance. Therefore, it is desirable to provide an electronic device that can reasonably achieve a high heat dissipation effect only by contact between solids, like an optical transceiver including a heat sink or the like.

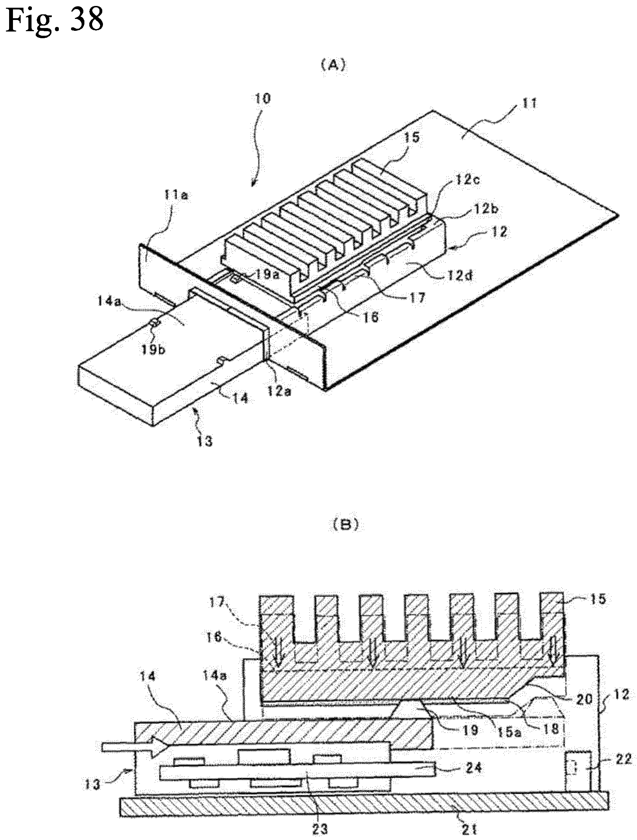

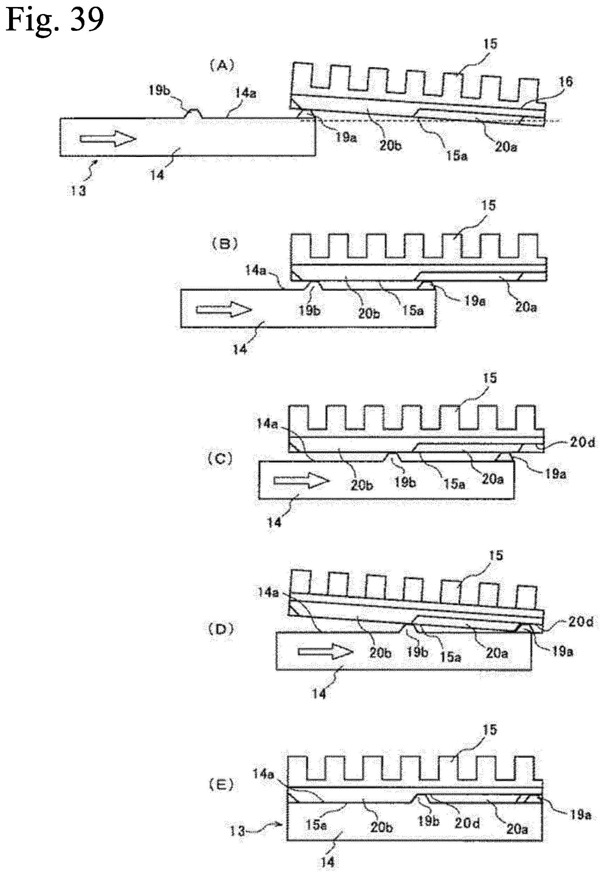

A structure of the electronic device of such a type is disclosed in, for example, Japanese Patent Laid-Open No. 2009-152428. An optical transceiver (13) as an existing electronic device disclosed in Japanese Patent Laid-Open No. 2009-152428 is of a type in which a transceiver housing (14) and a heat conductive sheet (18) are brought into press-contact with each other through cam protrusions (19a and 19b) as illustrated in FIG. 38 and FIG. 39. More specifically, in the optical transceiver (13) as the existing electronic device, the soft heat conductive sheet (18) is stuck to one of a contact surface of a heat sink (15) disposed above a cage (12) installed on a host substrate (11) and a contact surface of a transceiver housing (14). The heat sink (15) is supported by the cage (12) so as to be movable elastically downward within a predetermined range, and cam protrusions (19) are provided on the contact surface (14a) of the transceiver housing (14) so as to separate the contact surface (15a) of the heat sink (15) within a predetermined range. Further, Japanese Patent Laid-Open No. 2009-152428 discloses that the transceiver housing (14) is inserted into the cage (12) without rubbing a contact surface of the heat conductive sheet (18), and the contact surface of the heat sink (15) and the contact surface of the transceiver housing (14) are brought into press-contact with each other with the heat conductive sheet (18) in between at a final insertion position of the transceiver housing (14). Note that reference numerals relating to description of the related art document are distinguished from an embodiment of the present invention by adding parentheses.

In the optical transceiver (13) disclosed in Japanese Patent Laid-Open No. 2009-152428, in a case where the cam protrusions (19a and 19b) are in contact with an upper surface of a cam groove (20d) as illustrated in FIG. 39(E) illustrating a pressure contact state, there is an issue that stable pressure contact over the entire surface of the heat conductive sheet (18) is difficult. As countermeasures for avoiding the issue, a clearance may be provided such that the cam protrusions (19a and 19b) are not in contact with the upper surface of the cam groove (20d) in the pressure contact state illustrated in FIG. 39(E). However, when an inclined surface is provided on any of an inclination surface (20c) and the cam protrusion (19b), an issue that the transceiver housing (14) and the heat conductive sheet (18) slide on and rub each other immediately before the final insertion position of the optical transceiver (13) remains.

Therefore, an object of the present invention is to provide an electronic device having a structure in which a heat sink (a heat conductive sheet in the case where the heat conductive sheet is attached) can be stably pressed against a plug shell serving as a heat generation body over an entire surface without sliding on the plug shell.

SUMMARY OF THE INVENTION

An electronic device according to an aspect of the present invention includes: a plug connector including a plug shell and a plug housing; a receptacle housing including an opening into/from which the plug connector is insertable/extractable; and a heat sink movably installed on the receptacle housing by being installed through a receptacle shell attached to the receptacle housing. When the plug connector is inserted into the opening of the receptacle housing and a fitted state is established, the plug shell and a heat releasing surface of the heat sink come into contact with each other, and the heat sink dissipates heat generated from the plug connector. When an insertion/extraction direction of the plug connector into/from the opening of the receptacle housing is defined as a first direction, the extraction direction of the plug connector from the opening is defined as a positive first direction, the insertion direction is defined as a negative first direction, a direction orthogonal to the first direction is defined as a second direction, a direction in which the plug shell and the heat releasing surface of the heat sink are separated from each other is defined as a positive second direction, and a direction in which the plug shell and the heat releasing surface of the heat sink come close to each other is defined as a negative second direction, the heat sink is supported to be movable in the first direction and the second direction relative to the receptacle shell, first pressing means configured to press the heat sink in the positive first direction relative to the receptacle shell and second pressing means configured to press the heat sink in the negative second direction relative to the receptacle shell are disposed between the heat sink and the receptacle shell, the receptacle shell includes a guide portion configured to lift up the heat sink in the positive second direction when the heat sink is at a position in the positive first direction relative to the receptacle shell, and to enable the heat sink to move in the negative second direction when the heat sink is at a position in the negative first direction relative to the receptacle shell, the heat sink includes a guided portion configured to be guided by the guide portion provided on the receptacle shell, the heat sink and the plug connector include respective abutting surfaces abutting on each other in the first direction when the plug connector is inserted into the opening of the receptacle housing.

In other words, in the electronic device according to the aspect of the present invention, when the plug connector is inserted into the opening of the receptacle housing, the contact surface of the heat sink and the contact surface of the plug shell do not rub each other. After the contact surface of the heat sink and the contact surface of the plug shell come into contact with each other, the heat sink is pressed against the plug shell, is moved integrally with the plug shell, and reaches the final insertion position of the plug shell. Therefore, problems such as abrasion do not occur.

In the electronic device according to a preferred embodiment of the present invention, the plug housing may include a locking portion serving as fixing means, the receptacle housing may include a locked portion serving as fixed means, and when the plug connector is inserted into the opening of the receptacle housing and the fitted state is established, the locking portion and the locked portion may engage with each other to maintain the fitted state of the plug connector to the receptacle housing against pressing force by the first pressing means.

In other words, in the electronic device according to this preferred embodiment of the present invention, when the plug connector is inserted into the opening of the receptacle housing, and the fitted state is established, the fitted state is stably maintained.

In the electronic device according to a preferred embodiment of the present invention, the first pressing means and the second pressing means can be configured as members integrated with the receptacle shell.

In the electronic device according to a preferred embodiment of the present invention, the first pressing means and the second pressing means can be configured as members separated from the receptacle shell.

In the electronic device according to a preferred embodiment of the present invention, a clearance groove for releasing pressing force from the second pressing means is preferably provided at a portion of the heat sink receiving the pressing force from the second pressing means, in a state before the plug connector is preferably inserted into the opening of the receptacle housing, the second pressing means is preferably positioned at a formation position of the clearance groove to establish a state where all or part of the pressing force from the second pressing means is not preferably applied to the heat sink, and when the plug connector is inserted into the opening of the receptacle housing and the fitted state is preferably established, the position of the second pressing means is preferably deviated from the formation position of the clearance groove to establish a state where all or part of the pressing force from the second pressing means is preferably applied to the heat sink.

In the electronic device according to a preferred embodiment of the present invention, when the plug connector is inserted into the opening of the receptacle housing and the fitted state is preferably established, a surface of the heat sink receiving the pressing force from the second pressing means can be formed as an inclined surface directing at least a part of load components of the pressing force toward the first direction.

In the electronic device according to a preferred embodiment of the present invention, each of the first pressing means and the second pressing means can be formed as a cantilever spring having a cantilever shape or a double-end supported spring having a double-end supported beam shape.

In the electronic device according to a preferred embodiment of the present invention, an inequality of P1 > P2 is preferably established, where P1 is pressing force of the first pressing means, and P2 is force in the negative first direction by pressing force of the second pressing means.

In the electronic device according to a preferred embodiment the present invention, a heat conductive sheet can be installed on the heat releasing surface of the heat sink.

In the electronic device according to a preferred embodiment of the present invention, the guide portion is preferably formed as a cam groove having a groove shape, and the guide portion preferably has a substantially L-shaped groove shape.

In the electronic device according to a preferred embodiment of the present invention, the guided portion is preferably formed as a columnar protrusion to be fitted into the groove shape of the guide portion, and the substantially L-shaped groove shape of the guide portion may include a guide shape configured to guide motion of the guided portion inside the groove, the guide shape being formed by expanding a groove inner diameter of a right angle part bent in the substantially L-shape.

According to the present invention, it is possible to provide the electronic device having the structure in which the heat sink (a heat conductive sheet in the case where the heat conductive sheet is attached) can be stably pressed against the plug shell serving as the heat generation body over an entire surface without sliding on the plug shell.

BRIEF DESCRIPTION OF THE DRAWINGS

FIG. 1 is an appearance perspective view illustrating an entire configuration of an electronic device according to a present embodiment in a case where a state where a receptacle connector and a plug connector configuring the electronic device are fitted to each other is viewed from a front upper left side;
FIG. 2 is an appearance perspective view illustrating the entire configuration of the electronic device according to the present embodiment in a case where a state where the receptacle connector and the plug connector configuring the electronic device are not fitted to each other is viewed from the front upper left side;

FIG. 3 is an appearance perspective view in a case where the receptacle connector according to the present embodiment is viewed from the front upper left side;

FIG. 4 is an exploded perspective view illustrating a state where components of the receptacle connector according to the present embodiment illustrated in FIG. 3 are disassembled;

FIG. 5 is an appearance perspective view in a case where a heat sink that is a component of the receptacle connector according to the present embodiment is viewed from the front upper left side;

FIG. 6 is an appearance perspective view in a case where the heat sink that is the component of the receptacle connector according to the present embodiment is viewed from a front lower left side;

FIG. 7 is an appearance perspective view in a case where a receptacle shell that is a component of the receptacle connector according to the present embodiment is viewed from the front upper left side;

FIG. 8 is an appearance perspective view in a case where the receptacle shell that is the component of the receptacle connector according to the present embodiment is viewed from the front lower left side;

FIG. 9 is an appearance perspective view in a case where the receptacle shell that is the component of the receptacle connector according to the present embodiment is viewed from a rear lower left side;

FIG. 10 is an appearance perspective view in a case where the plug connector according to the present embodiment is viewed from the front upper left side;

FIG. 11 is an appearance perspective view in a case where the plug connector according to the present embodiment is viewed from a rear upper right side;

FIG. 12 is a diagram for explaining operation of the electronic device according to the present embodiment in a case where a non-fitted state where the plug connector is not inserted into an opening of a receptacle housing is viewed from the front upper left side;

FIG. 13 is a top view for explaining operation of the electronic device according to the present embodiment in the non-fitted state where the plug connector is not inserted into the opening of the receptacle housing;

FIG. 14 is a left side view for explaining operation of the electronic device according to the present embodiment in the non-fitted state where the plug connector is not inserted into the opening of the receptacle housing;

FIG. 15 is a vertical cross-sectional left side view illustrating a cross-section taken along line XV-XV in FIG. 13;

FIG. 16 is a cross-sectional bottom view illustrating a cross-section taken along line XVI-XVI in FIG. 14;

FIG. 17 is a diagram for explaining operation of the electronic device according to the present embodiment in a case where a halfway fitted state where the plug connector is being inserted into the opening of the receptacle housing is viewed from the front upper left side;

FIG. 18 is a top view for explaining operation of the electronic device according to the present embodiment in the halfway fitted state where the plug connector is being inserted into the opening of the receptacle housing;

FIG. 19 is a left side view for explaining operation of the electronic device according to the present embodiment in the halfway fitted state where the plug connector is being inserted into the opening of the receptacle housing;

FIG. 20 is a vertical cross-sectional left side view illustrating a cross-section taken along line XX-XX in FIG. 18;

FIG. 21 is a vertical cross-sectional left side view illustrating a cross-section taken along line XXI-XXI in FIG. 18;

FIG. 22 is a cross-sectional bottom view illustrating a cross-section taken along line XXII-XXII in FIG. 19;

FIG. 23 is a diagram for explaining operation of the electronic device according to the present embodiment in a case where a fitted state where the plug connector is completely inserted into the opening of the receptacle housing is viewed from the front upper left side;

FIG. 24 is a top view for explaining operation of the electronic device according to the present embodiment in the fitted state where the plug connector is completely inserted into the opening of the receptacle housing;

FIG. 25 is a left side view for explaining operation of the electronic device according to the present embodiment in the fitted state where the plug connector is completely inserted into the opening of the receptacle housing;

FIG. 26 is a vertical cross-sectional left side view illustrating a cross-section taken along line XXVI-XXVI in FIG. 24;

FIG. 27 is a vertical cross-sectional left side view illustrating a cross-section taken along line XXVII-XXVII in FIG. 24;

FIG. 28 is a cross-sectional bottom view illustrating a cross-section taken along line XXVIII-XXVIII in FIG. 25;

FIG. 29 is a diagram for explaining operation of the electronic device according to the present embodiment and illustrating positional relationship of a columnar protrusion to a cam groove;

FIG. 30 is an appearance perspective view in a case where a receptacle shell that is a component of a receptacle connector according to a modification is viewed from the front upper left side;

FIG. 31 is an appearance perspective view in a case where a heat sink that is a component of the receptacle connector according to the modification is viewed from the front upper left side;

FIG. 32 is a top view for explaining operation of an electronic device according to the modification in a halfway fitted state where a plug connector is being inserted into an opening of a receptacle housing;

FIG. 33 is a vertical cross-sectional left side view illustrating a cross-section taken along line XXXIII-XXXIII in FIG. 32;

FIG. 34 is a vertical cross-sectional left side view illustrating a cross-section taken along line XXXIV-XXXIV in FIG. 32;

FIG. 35 is a top view for explaining operation of the electronic device according to the modification in a fitted state where the plug connector is completely inserted into the opening of the receptacle housing;

FIG. 36 is a vertical cross-sectional left side view illustrating a cross-section taken along line XXXVI-XXXVI in FIG. 35;

FIG. 37 is a vertical cross-sectional left side view illustrating a cross-section taken along line XXXVII-XXXVII in FIG. 35;

FIG. 38 is a schematic diagram for explaining an outline of a heat dissipation device of an optical transceiver according to an existing technique; and

FIG. 39 is a diagram for explaining an operation state of a heat dissipation mechanism according to the existing technique.

## DETAILED DESCRIPTION OF THE INVENTION

A preferred embodiment for implementing the present invention is described below with reference to drawings. In the drawings, a first direction, a second direction, and a third direction are defined for convenience of description. In the present specification, the first direction is a front-rear direction. In the drawings, the front-rear direction is illustrated as a Y direction. In particular, a forward direction is a +Y direction, and a rearward direction is a -Y direction. The first direction is an insertion/extraction direction of a receptacle housing 41 and a plug connector 20 configuring an electronic device 10 according to the present embodiment. In other words, a direction in which the plug connector 20 is moved in the +Y direction relative to the receptacle housing 41 is the extraction direction, and a direction in which the plug connector 20 is moved in the -Y direction relative to the receptacle housing 41 is the insertion direction.

In the present specification, the second direction is an up-down direction. In the drawings, the up-down direction is illustrated as a Z direction. In particular, an upward direction is a +Z direction, and a downward direction is a -Z direction. The second direction is a separating/approaching direction of a plug shell 21 and a heat releasing surface of a heat sink 51 configuring the electronic device 10 according to the present embodiment. In other words, a direction in which the heat releasing surface of the heat sink 51 is moved in the +Z direction relative to the plug shell 21 is the separating direction, and a direction in which the heat releasing surface of the heat sink 51 is moved in the -Z direction relative to the plug shell 21 is the approaching direction.

In the present specification, the third direction is a left-right direction. In the drawings, the left-right direction is illustrated as an X direction. In particular, a leftward direction is a +X direction, and a rightward direction is a -X direction. The Y direction as the first direction, the Z direction as the second direction, and the X direction as the third direction defined in the present specification do not limit directions during use of the electronic device 10 according to the present embodiment. The electronic device 10 according to the present embodiment can be used in all directions.

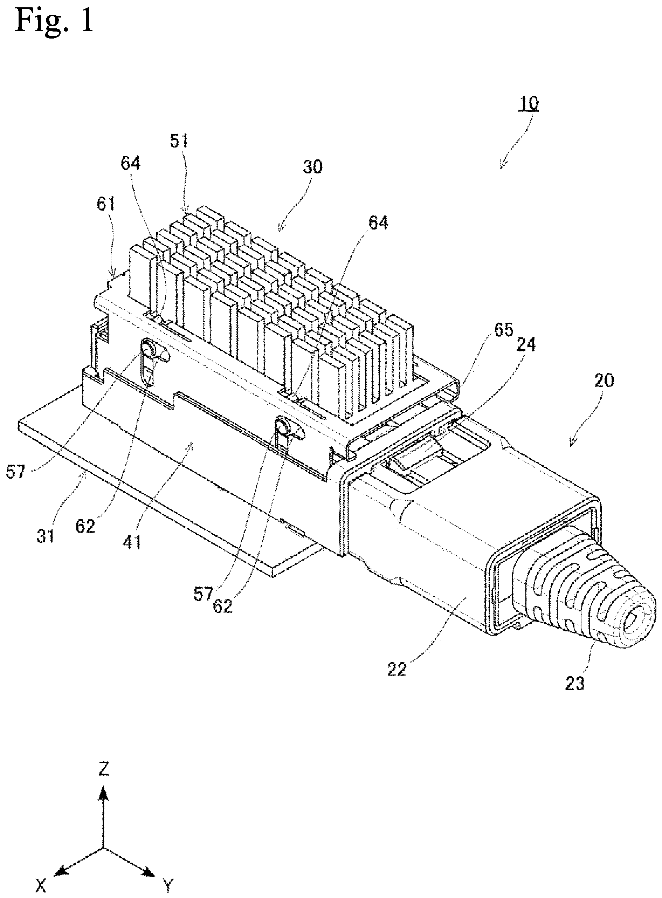

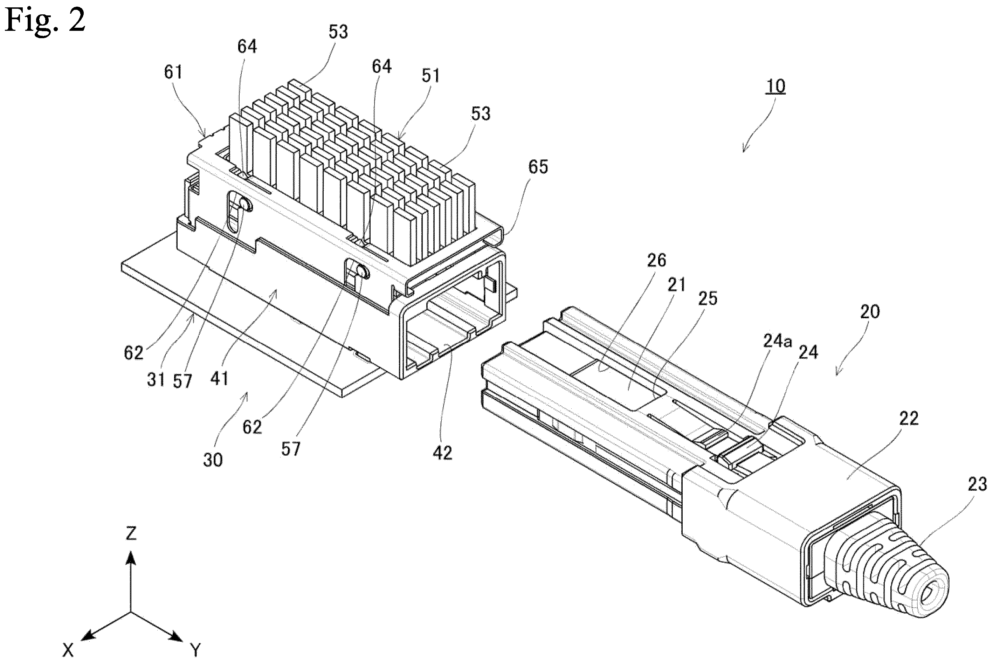

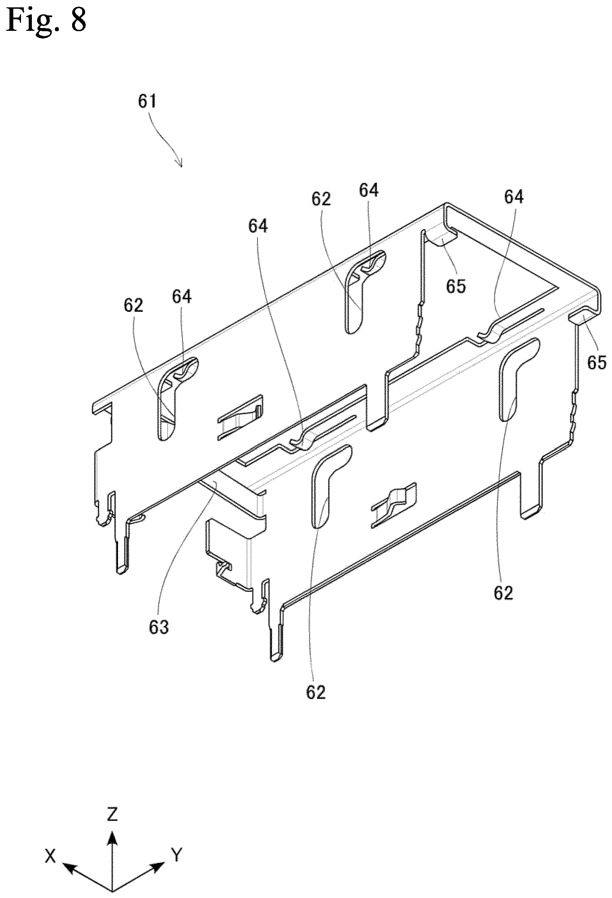

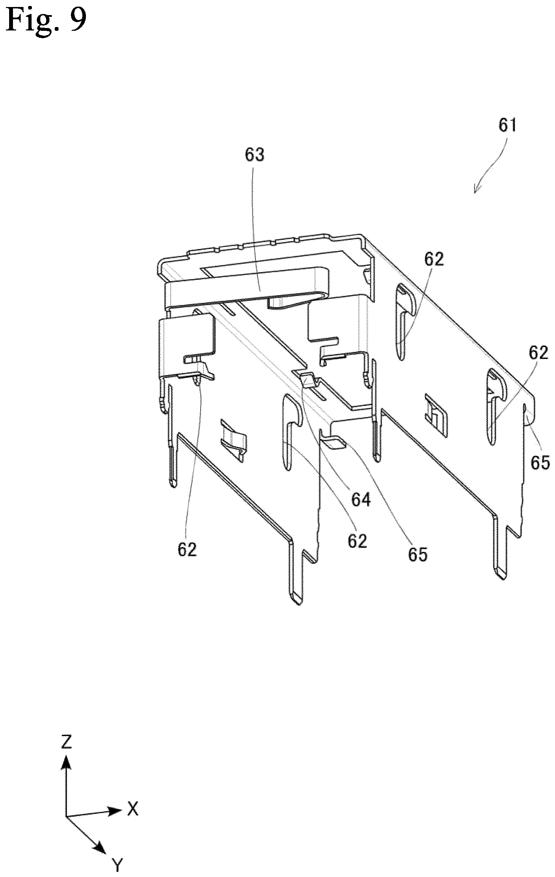

First, an entire configuration of the electronic device 10 according to the present embodiment is described with reference to FIG. 1 to FIG. 11. As illustrated in FIG. 1 and FIG. 2, the electronic device 10 according to the present embodiment includes the plug connector 20 and a receptacle connector 30. The plug connector 20 can be inserted into/extracted from the receptacle connector 30.

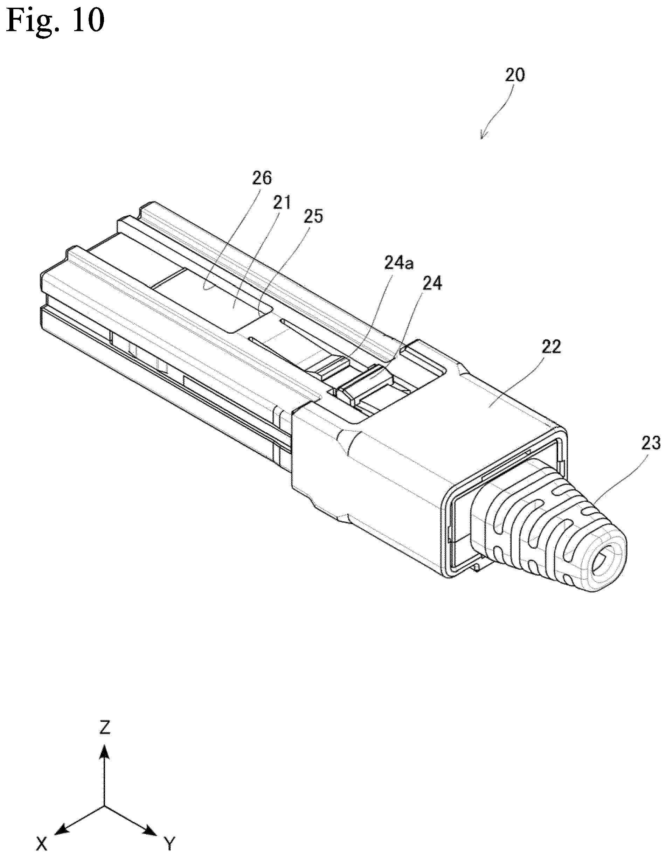

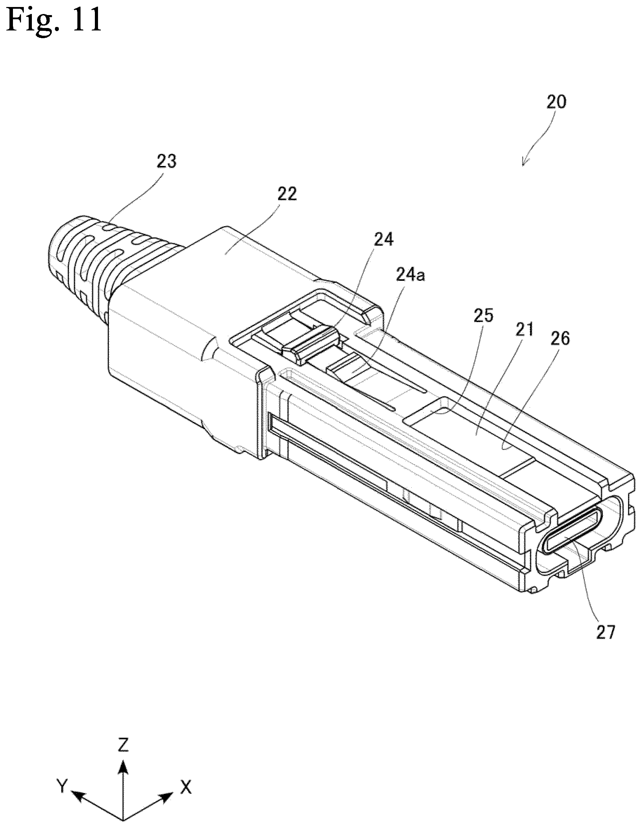

As illustrated in FIG. 10 and FIG. 11, the plug connector 20 includes the plug shell 21 and a plug housing 22. The plug shell 21 is made of a conductive metal material. In particular, as illustrated in FIG. 11, a plug-side fitting terminal 27 is disposed inside the plug shell 21. On the other hand, the plug housing 22 is made of a non-conductive material such as a resin and an elastomer, and is disposed to cover an outer periphery of the plug shell 21.

A cable attachment portion 23 to which cables such as electric cables and optical fibers are attached is provided on a front part of the plug housing 22. By installing unillustrated cables through the cable attachment portion 23 and connecting the cables to the plug-side fitting terminal 27, electric signals, power, optical information, and the like can be delivered.

Further, a locking portion 24 is provided on the plug housing 22. The locking portion 24 serves as fixing means for maintaining a fitted state of the receptacle housing 41 described below and the plug connector 20 when the plug connector 20 and the receptacle connector 30 are in a fitted state. The locking portion 24 according to the present embodiment has a double-end supported beam shape, and has a form including a claw 24a at a center part. Therefore, when the plug connector 20 is inserted into the receptacle housing 41 described below, the claw 24a at the center part is bent downward by coming into contact with a locked portion 45 provided as fixed means on the receptacle housing 41 described below. After the locking portion 24 climbs over the locked portion 45, the claw 24a returns to an original position and engages with the locked portion 45. In this manner, the function as the fixing means is exerted. In contrast, in the fitted state, the user presses the locking portion 24 downward from above in the -Z direction. As a result, the claw 24a at the center part is bent and moved downward, and disengages from the locked portion 45 of the receptacle housing 41 described below. Therefore, when the user extracts the plug connector 20 from the receptacle housing 41 described below in this state, the plug connector 20 can be released from the fitted state with the receptacle connector 30.

The plug housing 22 further includes a plug abutting surface 25 that abuts on the heat sink 51 in the first direction (in Y direction) when the plug connector 20 is inserted into an opening 42 of the receptacle housing 41 described blow. The plug abutting surface 25 is formed as a vertical flat surface directed in the -Y direction that is the rearward direction.

A plug opening 26 opening upward is provided on a rear side of the plug abutting surface 25. The plug opening 26 exposes the plug shell 21 installed inside the plug housing 22 upward. When a heat conductive sheet 56 installed on the heat releasing surface of the heat sink 51 described below comes into contact with an upper surface of the plug shell 21 in a state where an upper part is exposed by the plug opening 26, the heat sink 51 can dissipate heat generated from the plug connector 20.

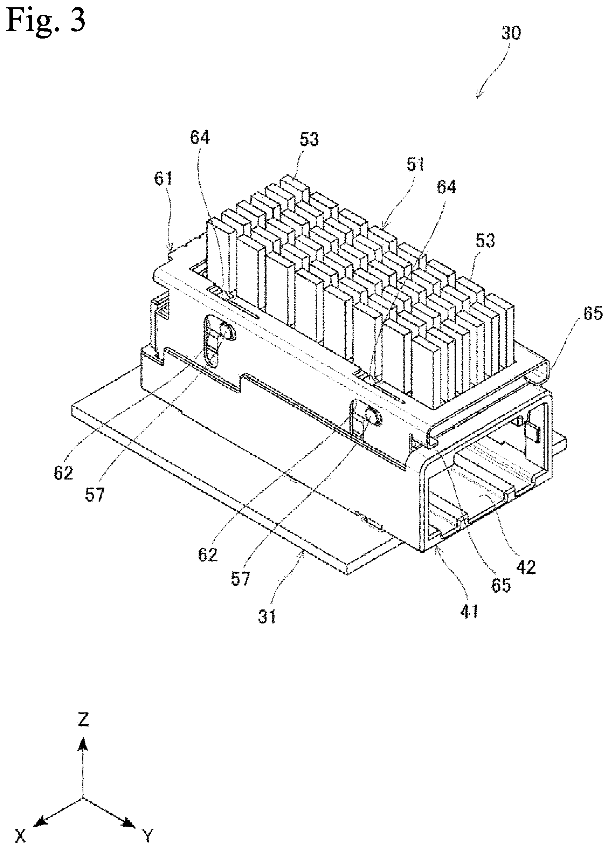

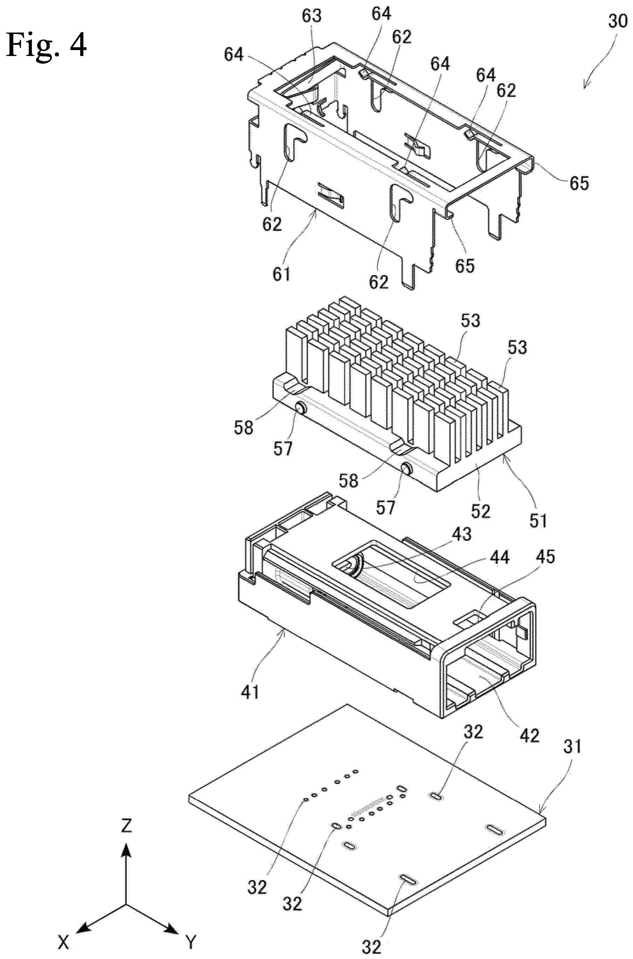

As illustrated in FIG. 3 and FIG. 4, the receptacle connector 30 includes a substrate 31, the receptacle housing 41, the heat sink 51, and a receptacle shell 61.

The substrate 31 includes an unillustrated printed circuit and the like. By electrically connecting the printed circuit to the receptacle housing 41 and the like attached to an upper surface of the substrate 31, electric signals, power, optical information, and the like can be delivered.

In particular, as illustrated in FIG. 4, the substrate 31 includes a plurality of attachment holes 32. Leg portions, terminals, and the like held by the receptacle housing 41 and the receptacle shell 61 are inserted into the plurality of attachment holes 32, and the receptacle housing 41 and the receptacle shell 61 are fixed to the substrate 31.

The receptacle housing 41 includes the opening 42 opening forward. The plug connector 20 is inserted into and extracted from the opening 42, which makes it possible to realize the fitted state and the non-fitted state of the plug connector 20 and the receptacle connector 30.

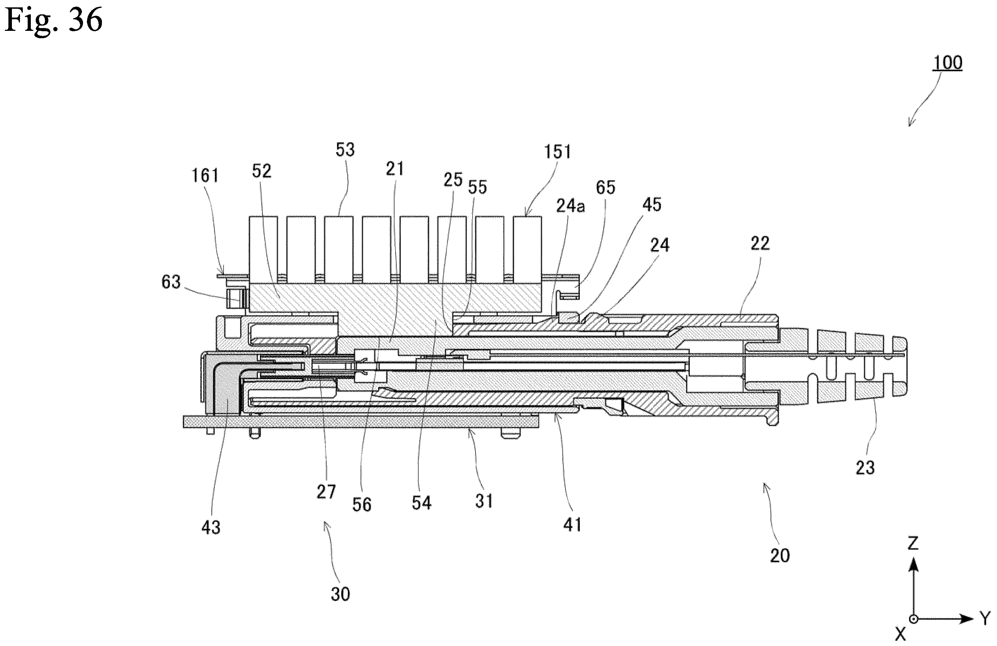

A receptacle-side fitting terminal 43 is disposed inside the receptacle housing 41. As illustrated in FIG. 36, the receptacle-side fitting terminal 43 is mounted on the surface of the substrate 31 by soldering, and can be electrically connected to the substrate 31 including the unillustrated printed circuit and the like. When the plug connector 20 and the receptacle connector 30 are in the fitted state, the receptacle-side fitting terminal 43 and the plug-side fitting terminal 27 come into contact with each other. Therefore, electric signals, power, optical information, and the like from the unillustrated cables can be delivered to the substrate 31 through the plug connector 20 and the receptacle connector 30.

An upward open hole 44 opening upward is provided at an upper center part of the receptacle housing 41. The upward open hole 44 has an open hole shape such that the plug shell 21 inserted into the opening 42 of the receptacle housing 41 and the heat releasing surface of the heat sink 51 described below face each other and come into contact with each other.

Further, as illustrated in FIG. 4, the locked portion 45 is provided at an upper front part of the receptacle housing 41. The locked portion 45 serves as the fixed means for engaging with the locking portion 24 held by the above-described plug connector 20. The locked portion 45 has a hole shape into which the claw 24a configuring the locking portion 24 is fitted, and a horizontal wall surface on a front side of the hole shape. Therefore, when the plug connector 20 is inserted into the receptacle housing 41, the claw 24a configuring the locking portion 24 is bent downward by coming into contact with the horizontal wall surface configuring the locked portion 45 of the receptacle housing 41. After the claw 24a climbs over the horizontal wall surface configuring the locked portion 45, the claw 24a returns to the original position and engages with the hole shape configuring the locked portion 45. In this manner, the function as the fixing means is exerted. In contrast, in the fitted state, the user presses the locking portion 24 downward from above in the -Z direction. As a result, the claw 24a is bent and moved downward, and disengages from the hole configuring the locked portion 45. Therefore, when the user extracts the plug connector 20 from the receptacle housing 41 in this state, the plug connector 20 can be released from the fitted state with the receptacle connector 30.

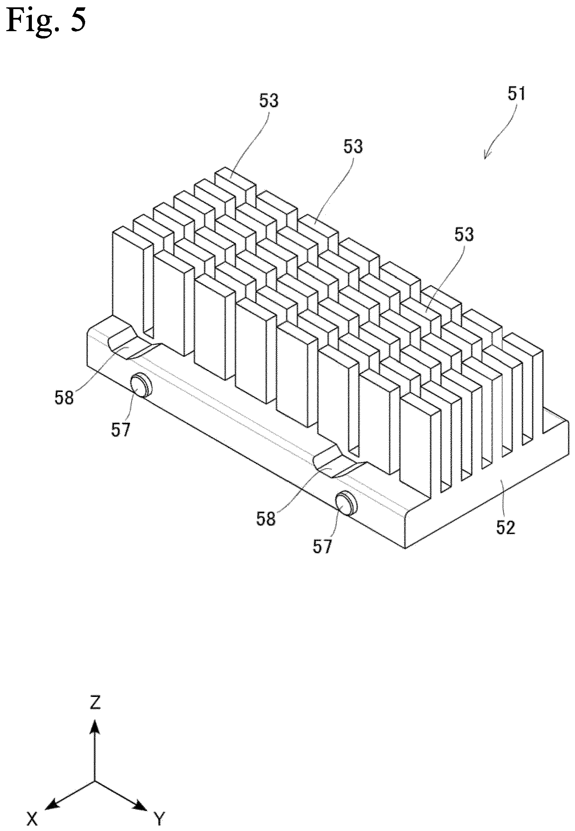

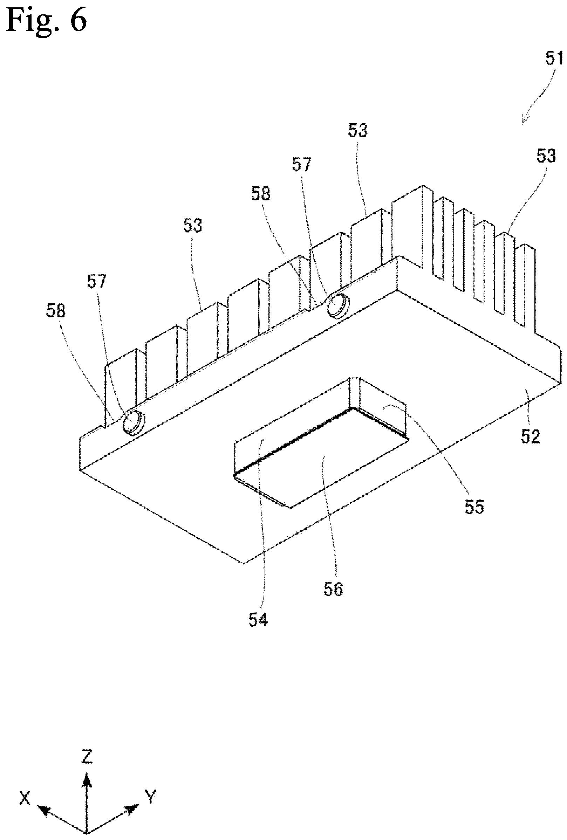

In particular, as illustrated in FIG. 5 and FIG. 6, the heat sink 51 includes a base portion 52 having a flat plate shape on a lower part, and a fin-shaped portion 53 formed as a plurality of walls standing upward from the base portion 52. The heat sink 51 is made of a metal material having high heat conductivity, for example, an aluminum alloy. The heat sink 51 has a large surface area because of presence of the fin-shaped portion 53 formed as the plurality of walls. Thus, the heat sink 51 is a member having high heat dissipation efficiency.

The plug shell 21 that is a heat dissipation target of the heat sink 51 is positioned below the heat sink 51. Therefore, a protruding portion 54 having a rectangular shape is provided on a lower surface of the base portion 52 configuring the heat sink 51. The heat conductive sheet 56 is installed on a lower surface of the protruding portion 54 because the lower surface of the protruding portion 54 serves as the heat releasing surface of the heat sink 51. By installing the heat conductive sheet 56 at a portion coming into contact with the plug shell 21 that is the heat dissipation target, heat resistance (difficulty of heat conduction) can be reduced, and higher heat dissipation effect can be achieved.

A front-side surface of the protruding portion 54 is a heat sink abutting surface 55 abutting on the above-described plug abutting surface 25, and is formed as a vertical flat surface directed in the +Y direction that is the forward direction. Therefore, when the plug connector 20 is inserted into the opening 42 of the receptacle housing 41, the heat sink abutting surface 55 of the heat sink 51 and the plug abutting surface 25 of the plug housing 22 are disposed to face each other in the first direction, and come into contact with each other.

Further, four columnar protrusions 57 protruding in the left-right direction are provided on left and right side surfaces of the base portion 52 of the heat sink 51. The four columnar protrusions 57 are formed as guided portions according to the present invention. The four columnar protrusions 57 are members to be fitted into cam grooves 62 that are guide portions according to the present invention provided in the receptacle shell 61 described below.

Four clearance grooves 58 recessed downward are provided at left and right positions on the front side and the rear side on the upper surface of the base portion 52 of the heat sink 51. The four clearance grooves 58 have functions of adjusting pressing force from second pressing means held by the receptacle shell 61 described below, to an appropriate value.

The receptacle shell 61 is a member for movably installing the heat sink 51 on the receptacle housing 41. The receptacle shell 61 includes two cam grooves 62 on left and right side surfaces, namely, four cam grooves 62 in total. The four cam grooves 62 are formed as the guide portions according to the present invention. When the four columnar protrusions 57 held by the heat sink 51 are fitted into the four cam grooves 62, the heat sink 51 is movably supported to the receptacle shell 61 within formation ranges of the four cam grooves 62. Further, each of the four cam grooves 62 has a substantially L-shaped groove shape. Therefore, the heat sink 51 attached to the receptacle shell 61 is supported so as to be movable in the front-rear direction that is the first direction and in the up-down direction that is the second direction.

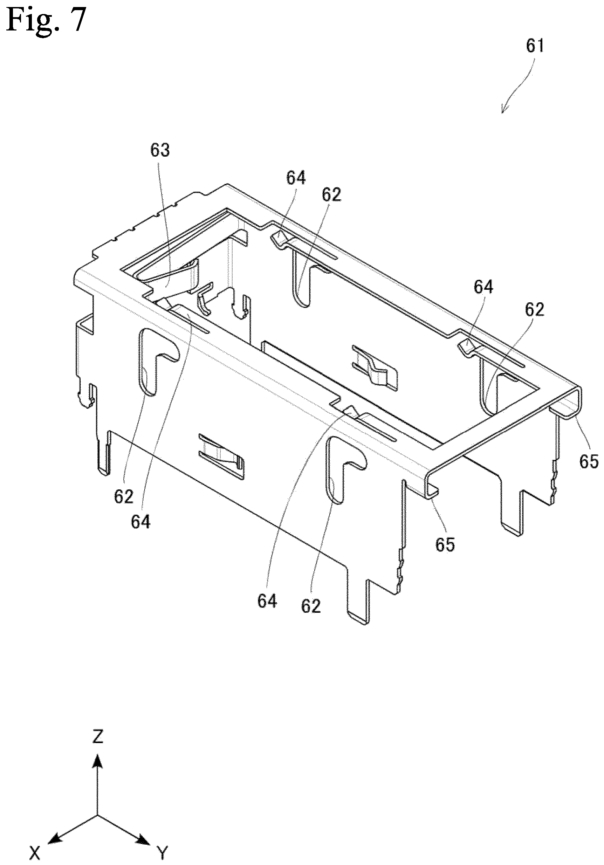

As illustrated in FIG. 7 to FIG. 9, the receptacle shell 61 includes first pressing means 63 and second pressing means 64. The first pressing means 63 presses the heat sink 51 attached using the cam grooves 62 in the forward direction (in +Y direction) that is a positive first direction, relative to the receptacle shell 61. The second pressing means 64 presses the heat sink 51 in the downward direction (in -Z direction) that is a negative second direction, relative to the receptacle shell 61. In the present embodiment, each of the first pressing means 63 and the second pressing means 64 is formed as a cantilever spring having a cantilever shape configured as a member integrated with the receptacle shell 61.

As illustrated in FIG. 7 to FIG. 9, the receptacle shell 61 includes stopper portions 65. When the heat sink 51 attached using the cam grooves 62 is pressed in the forward direction (in +Y direction) that is the positive first direction by pressing force of the first pressing means 63, the stopper portions 65 come into contact with the heat sink 51 to define a stop position of the heat sink 51. The stopper portions 65 define a moving range limit of the heat sink 51 pressed by the first pressing means 63 in the forward direction (in +Y direction) that is the positive first direction.

Since the receptacle shell 61 according to the present embodiment has the above-described configuration, the receptacle connector 30 is completed by inserting the receptacle shell 61 into the receptacle housing 41 downward from above (in -Z direction) in the state where the heat sink 51 is attached using the cam grooves 62.

The heat sink 51 attached using the cam grooves 62 of the receptacle shell 61 is configured to be lifted up in the upward direction (in +Z direction) that is the positive second direction when the heat sink 51 is positioned in the forward direction (in +Y direction) that is the positive first direction relative to the receptacle shell 61 (e.g., see state illustrated in FIG. 3), and to be movable in the downward (in -Z direction) that is the negative second direction when the heat sink 51 is positioned in the rearward direction (in -Y direction) that is the negative first direction relative to the receptacle shell 61 (e.g., see state illustrated in FIG. 1), by action of the shapes of the cam grooves 62 and action of spring elastic force from the first pressing means 63 and the second pressing means 64. When the heat sink 51 is installed on the receptacle housing 41 through the receptacle shell 61 in the above-described manner, the heat sink 51 is movably installed on the receptacle housing 41.

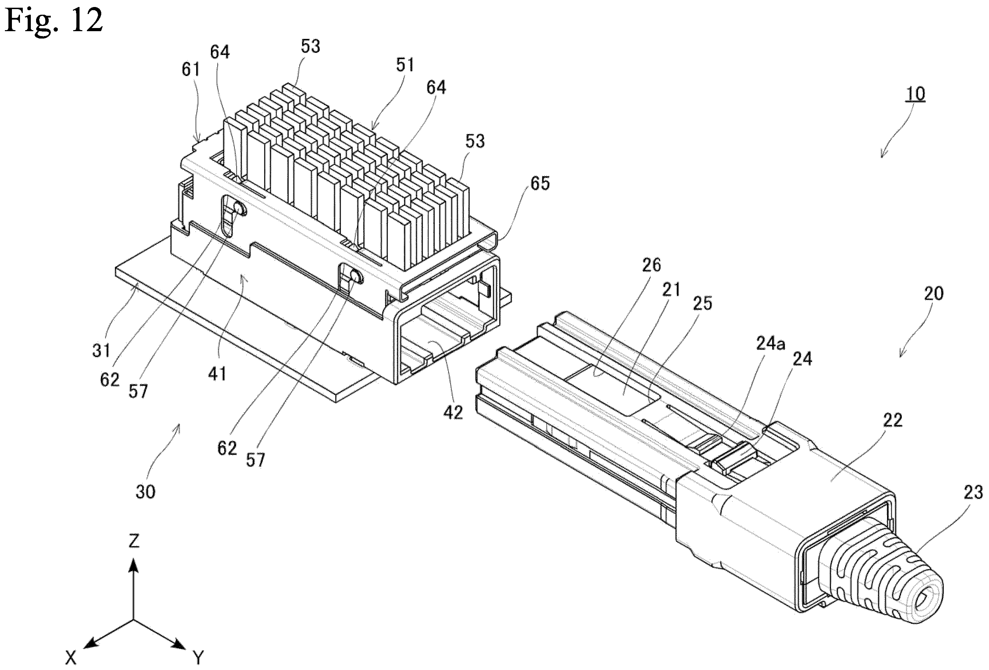

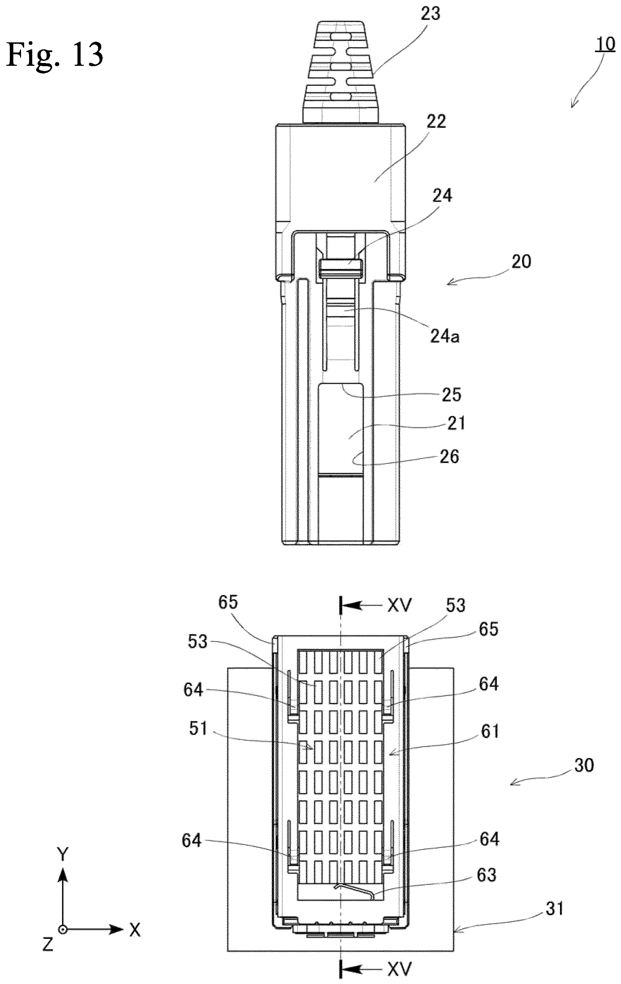

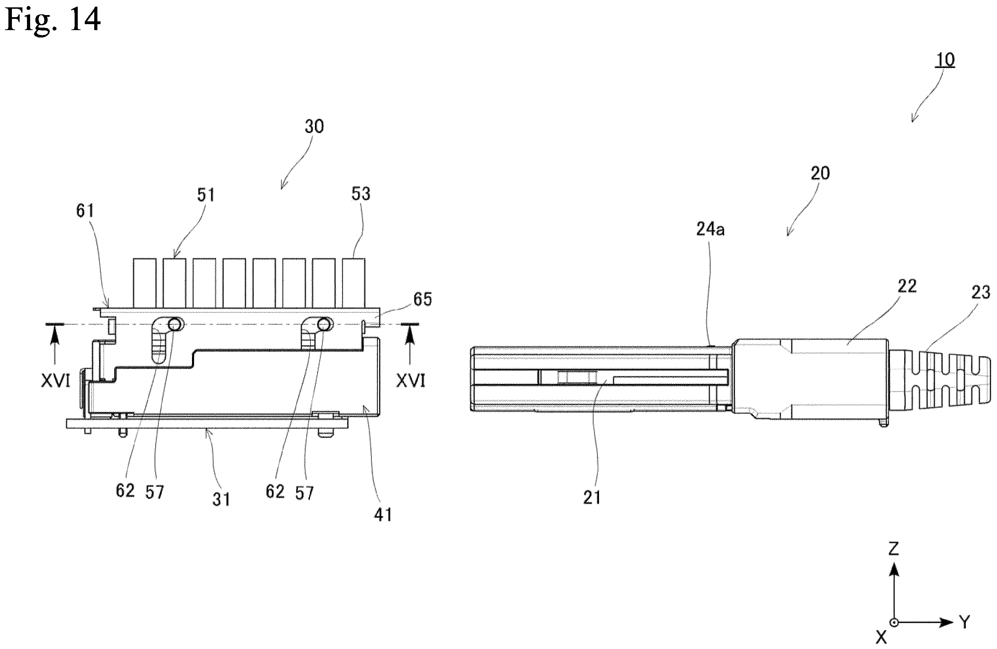

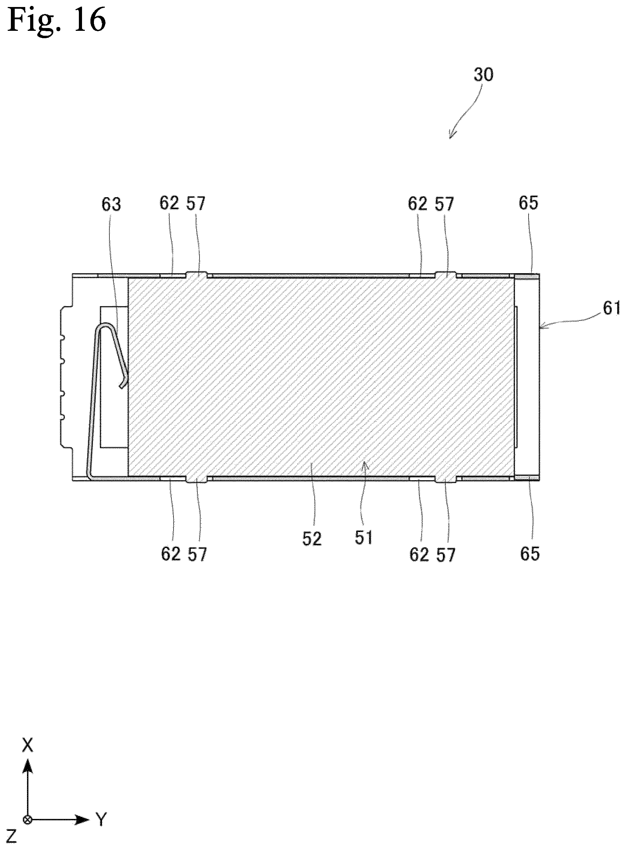

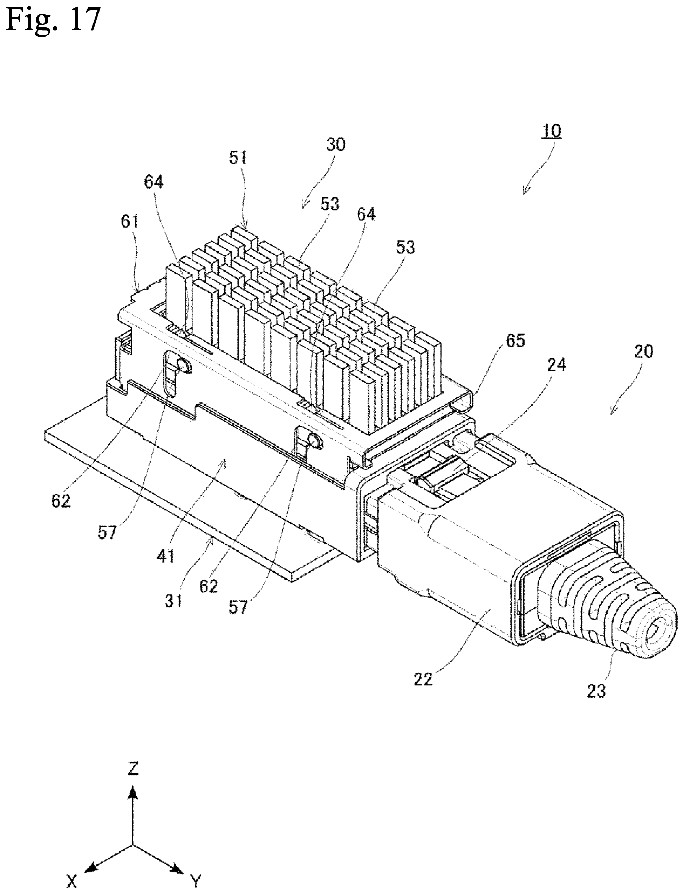

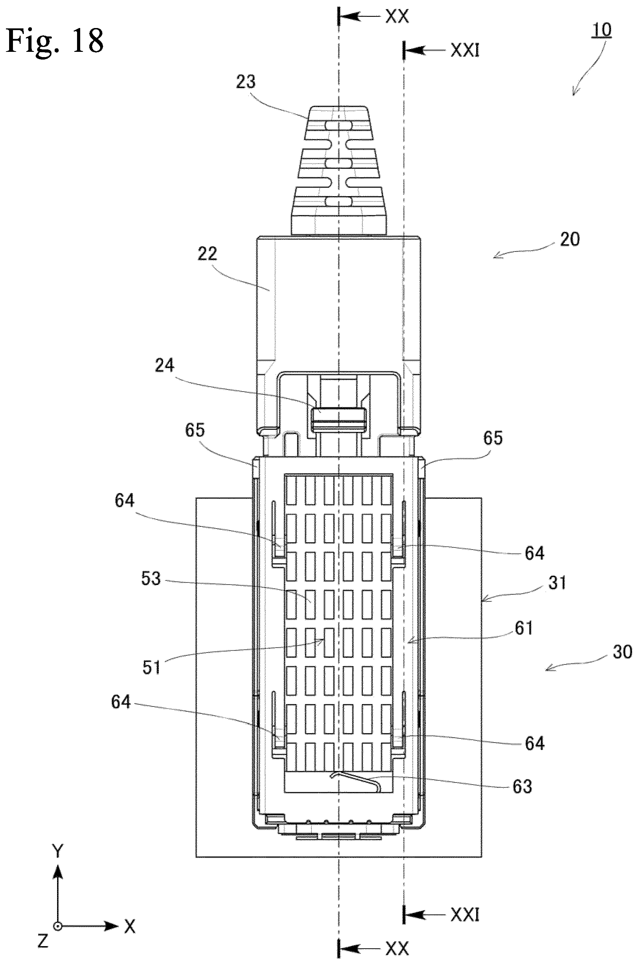

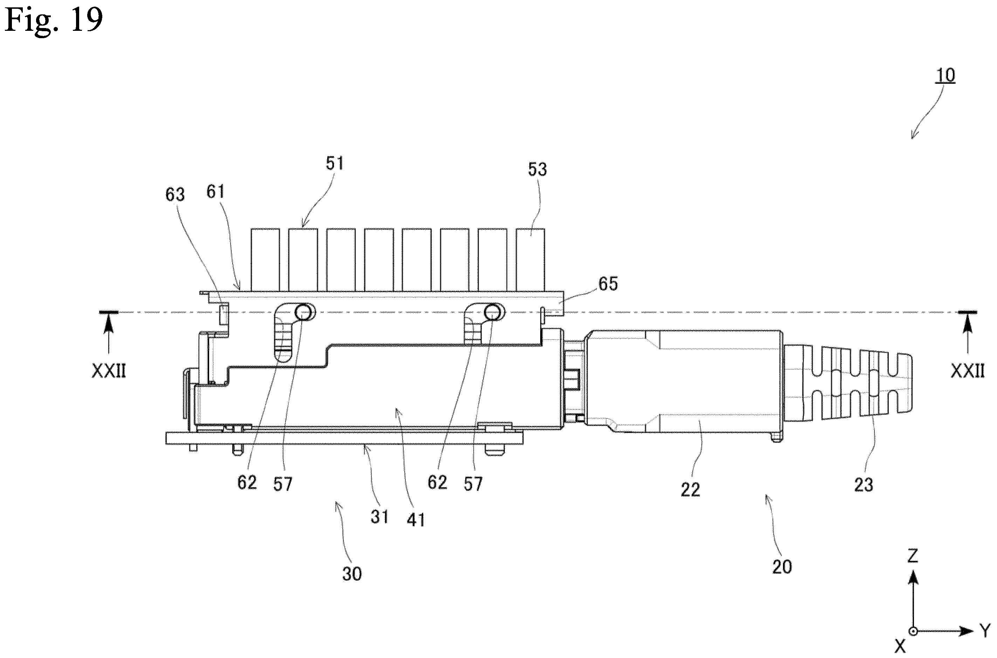

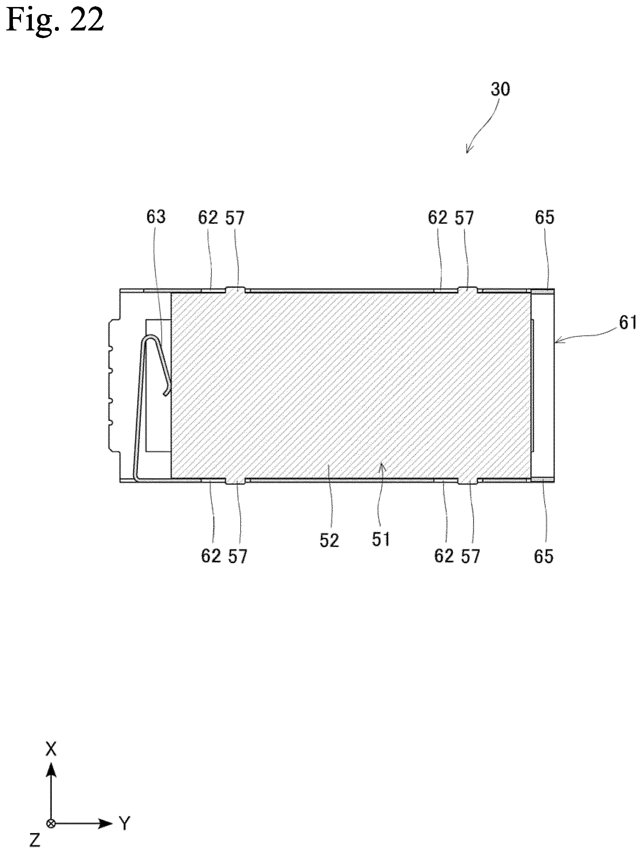

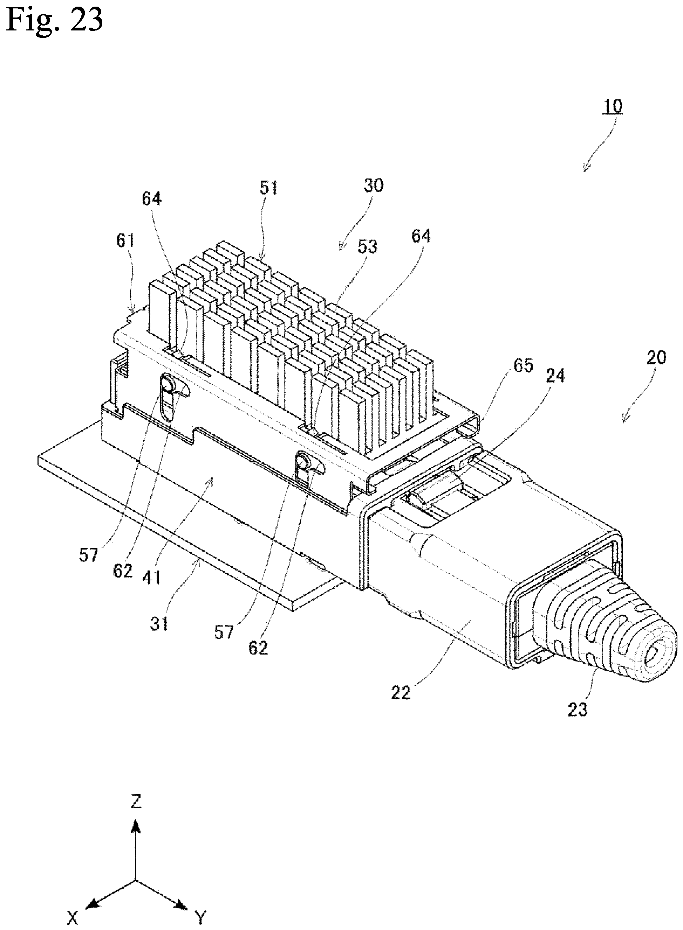

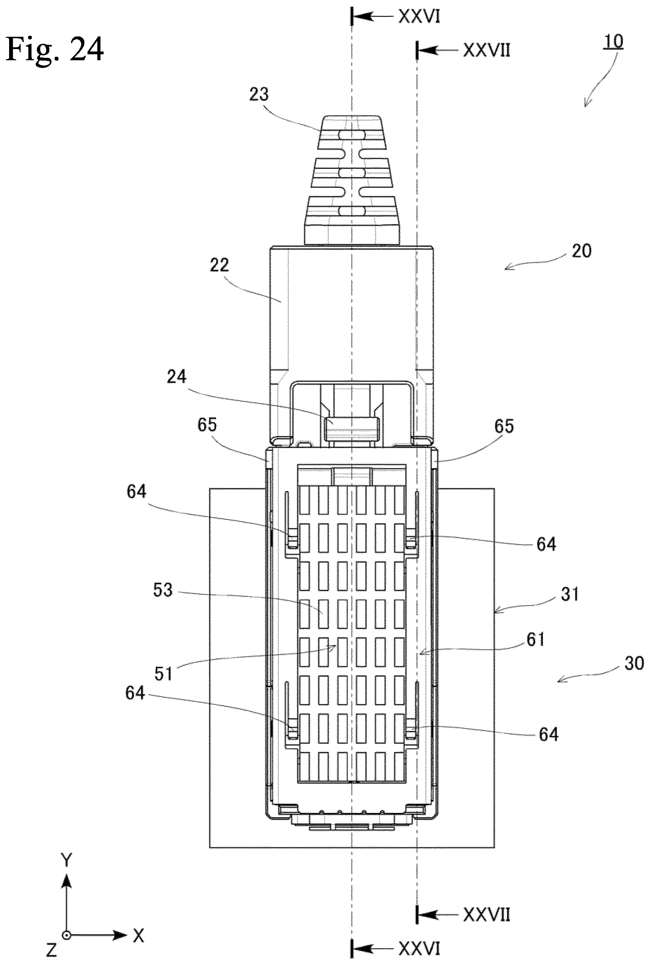

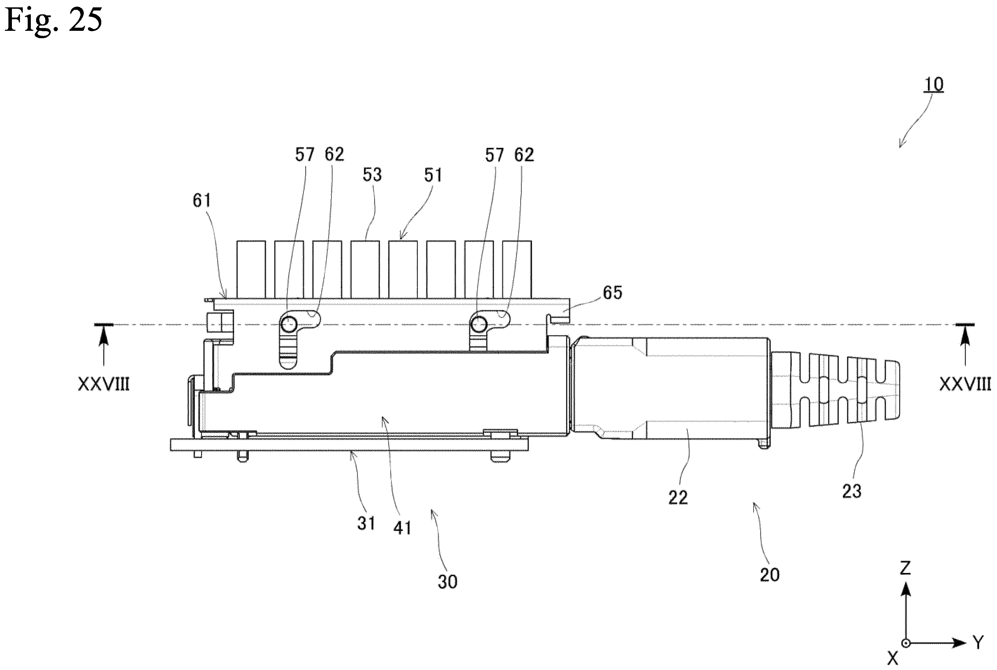

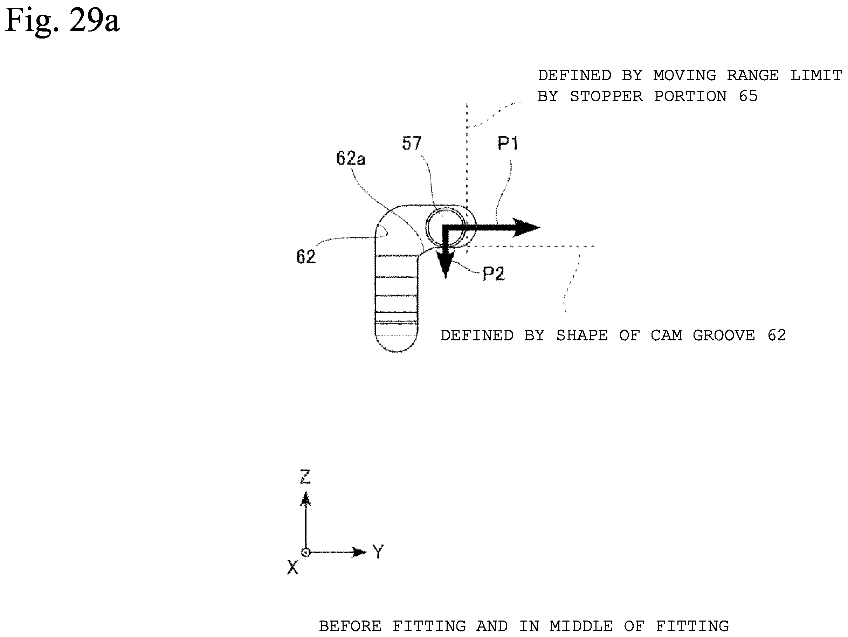

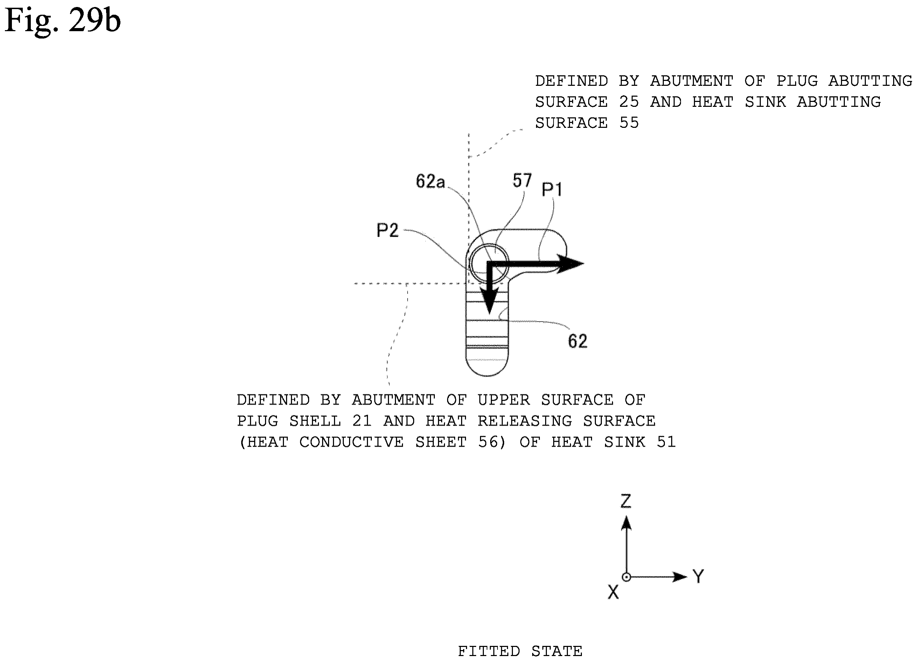

The entire configuration of the electronic device 10 according to the present embodiment is described above with reference to FIG. 1 to FIG. 11. Next, specific operation of the electronic device 10 according to the present embodiment is described with reference to FIG. 12 to FIG. 29. FIG. 12 to FIG. 16 illustrate a non-fitted state where the plug connector 20 is not inserted into the opening 42 of the receptacle housing 41. FIG. 17 to FIG. 22 illustrate a halfway fitted state where the plug connector 20 is being inserted into the opening 42 of the receptacle housing 41. FIG. 23 to FIG. 28 illustrate a fitted state where the plug connector 20 is completely inserted into the opening 42 of the receptacle housing 41. FIG. 29 illustrates positional relationship of one columnar protrusion 57 to the corresponding cam groove 62.

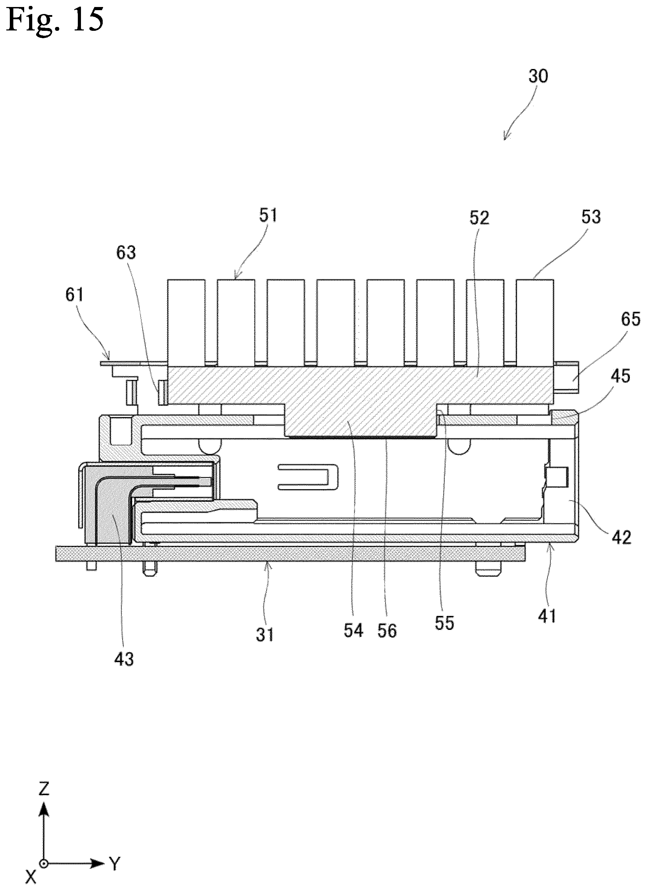

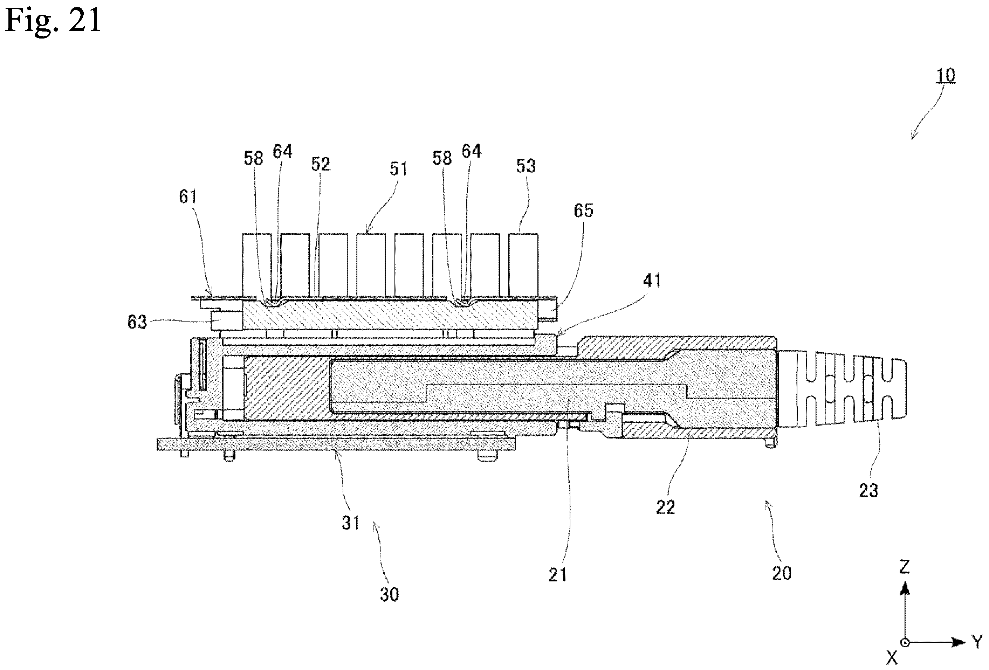

In the non-fitted state where the plug connector 20 is not inserted into the opening 42 of the receptacle housing 41 illustrated in FIG. 12 to FIG. 16, in particular, as illustrated in FIG. 15, the heat sink 51 is pressed in the forward direction (in +Y direction) that is the first direction, by the first pressing means 63 provided on the receptacle shell 61. At this time, a front part of the heat sink 51 abuts on the stopper portions 65, and the columnar protrusions 57 provided on the left and right side surfaces of the heat sink 51 are lifted up in the upward direction (in +Z direction) that is the positive second direction, to positions not interfering with the plug shell 21 by the cam grooves 62 provided in the receptacle shell 61. The receptacle shell 61 includes the second pressing means 64 for pressing the heat sink 51 in the downward direction (in - Z direction) that is the negative second direction in the fitted state. However, in the non-fitted state, it is unnecessary for the second pressing means 64 to press the heat sink 51 in the downward direction (in -Z direction). Thus, the second pressing means 64 is at the formation positions of the respective clearance grooves 58 provided in the heat sink 51 (see FIG. 21 because of being similar to halfway fitted state described below). However, pressing force in the downward direction (in -Z direction) by the second pressing means 64 may be set so as to slightly press the clearance grooves 58 provided in the heat sink 51.

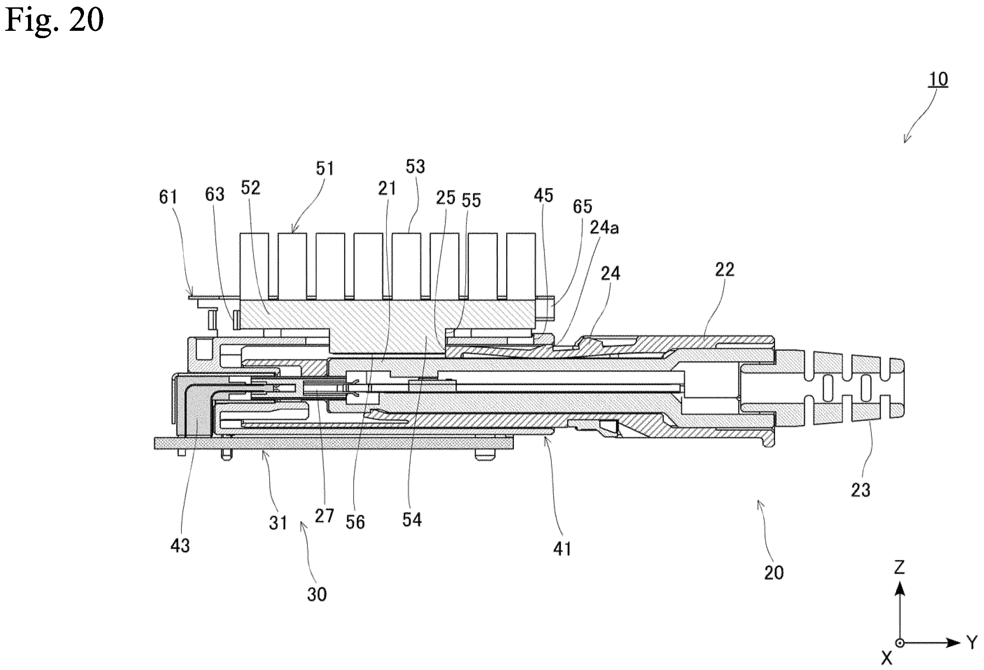

FIG. 17 to FIG. 22 illustrate the halfway fitted state where the plug connector 20 is being inserted into the opening 42 of the receptacle housing 41 from the non-fitted state. In particular, FIG. 20 illustrates, as the halfway fitted state, a state where the plug abutting surface 25 and the heat sink abutting surface 55 abut on each other for the first time in the middle of insertion of the plug connector 20 into the opening 42 of the receptacle housing 41. In this state, the heat sink 51 is at the position same as the position in the non-fitted state, and the heat conductive sheet 56 is not in contact with the plug shell 21 as illustrated in FIG. 20. In the state illustrated in FIG. 20, the locking portion 24 held by the plug connector 20 comes into contact with the horizontal wall surface configuring the locked portion 45, the claw 24a is bent downward, and the locking portion 24 and the locked portion 45 do not yet engage with each other.

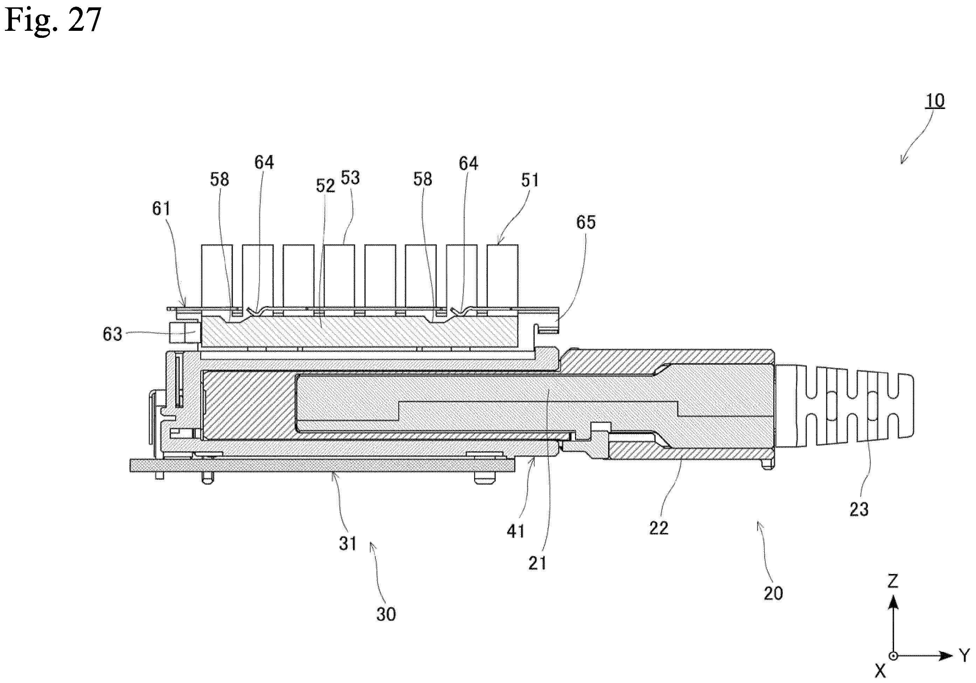

When the fitting further progresses from the halfway fitted state, the plug connector 20 and the heat sink 51 move in the rearward direction (in -Y direction) that is the negative first direction because the plug abutting surface 25 and the heat sink abutting surface 55 still abut on each other. At this time, the columnar protrusions 57 of the heat sink 51 also move in the rearward direction (in -Y direction) inside the respective cam grooves 62. Since the rear parts (in -Y direction) of the cam grooves 62 are formed in the downward direction (in -Z direction), the heat sink 51 can move in the downward direction (in -Z direction). In addition, since the clearance grooves 58 of the heat sink 51 also move in the rearward direction (in -Y direction), the second pressing means 64 climbs over inclined surfaces of the clearance groove 58 provided on the front side (in +Y direction), and presses the heat sink 51 in the downward direction (in -Z direction). FIG. 27 illustrate this state. By such behavior, the heat conductive sheet 56 is pressed against the plug shell 21, and the fitted state where the plug connector 20 is completely inserted into the opening 42 of the receptacle housing 41 as illustrated in FIG. 23 to FIG. 28 is realized.

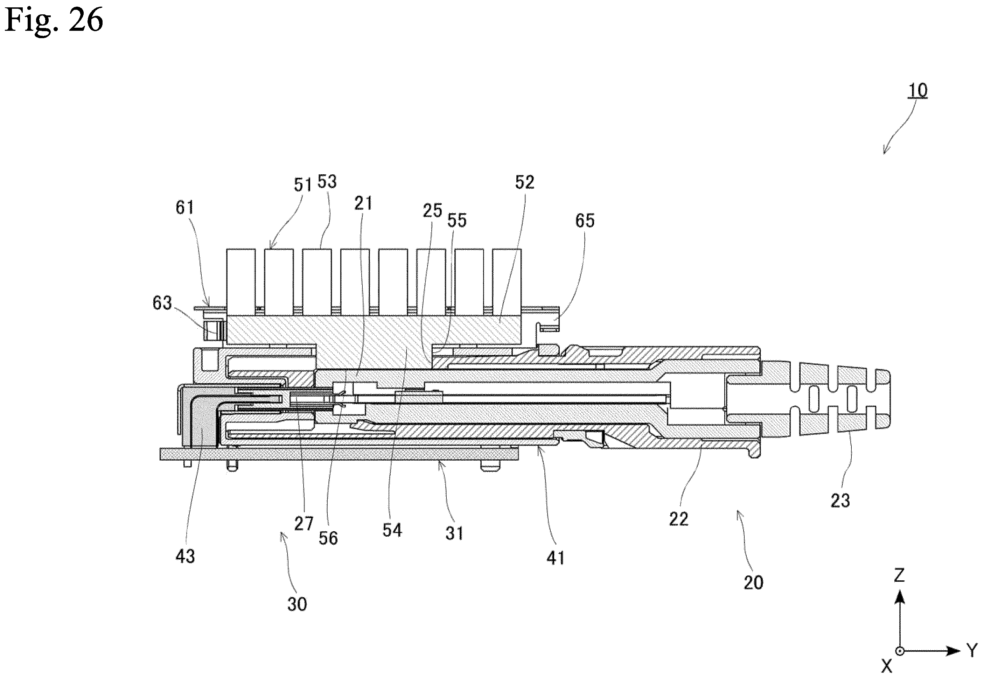

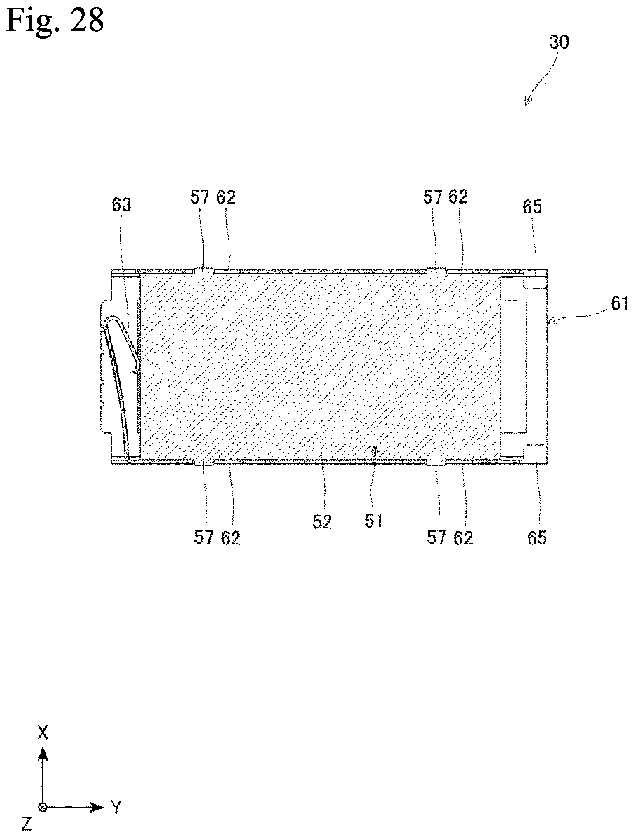

In the fitted state, as illustrated in FIG. 28, the heat sink 51 bends the first pressing means 63. Thus, force acts on the plug connector 20 in a separation direction that is the forward direction (+Y direction). However, as illustrated in FIG. 26, the locking portion 24 and the hole shape configuring the locked portion 45 engage with each other. Therefore, the force in the separation direction acting on the plug connector 20 is received by the locking portion 24 and the locked portion 45, and the fitted state is accordingly maintained.

While the state is shifted from the halfway fitted state to the fitted state described above, the plug abutting surface 25 continuously abuts on the heat sink abutting surface 55. Therefore, the heat sink 51 and the plug connector 20 both relatively move in the rearward direction (in -Y direction) without being shifted from each other in the Z direction (in up-down direction) that is the second direction, and the heat conductive sheet 56 and the plug shell 21 realize the contact state without sliding on each other.

Each of the cam grooves 62 according to the present embodiment has a substantially L-shaped groove shape. Although the groove shape of the lower part (-Z direction) of each of the cam grooves 62 has a length more than necessary, the shape is adopted to facilitate assembly of the heat sink 51 to the receptacle shell 61.

The operation when the plug connector 20 is inserted into the opening 42 of the receptacle housing 41 is described above. Next, separation operation when the plug connector 20 is extracted from the opening 42 of the receptacle housing 41 is described.

In the separation operation, the user presses the locking portion 24 downward from above in the downward direction (-Z direction). As a result, the claw 24a is bent and moved downward, and the locking portion 24 and the locked portion 45 disengage from each other. When the user extracts the plug connector 20 in the forward direction (in +Y direction) while maintaining the state, the separation operation can be performed. At this time, the first pressing means 63 presses the heat sink 51 in the forward direction (in +Y direction), and the columnar protrusions 57 of the heat sink 51 move in the forward direction (in +Y direction) inside the respective cam grooves 62. As a result, the heat sink 51 is lifted up to the halfway fitted state, and the heat conductive sheet 56 and the plug shell 21 are separated from each other in the Z direction (in up-down direction). The lift-up of the heat sink 51 during the separation operation is realized by movement of the columnar protrusions 57 in the upward direction (in +Z direction) by action of the shapes of the cam grooves 62 before movement of the columnar protrusions 57 in the forward direction (+Y direction) inside the respective cam grooves 62. Even in the separation operation, since the heat sink 51 and the plug connector 20 both relatively move in the forward direction (in +Y direction) without being shifted from each other in the Z direction (in up-down direction) that is the second direction while the heat conductive sheet 56 and the plug shell 21 are in contact with each other, the heat conductive sheet 56 and the plug shell 21 are not slid on each other.

In the separation operation, the pressing force (load of spring elastic force) of the first pressing means 63 is required to be greater than or equal to the pressing force of the second pressing means 64 (frictional force by contact of columnar protrusions 57 with cam grooves 62) in order to return the heat sink 51 to the original position. Such conditions are described with reference to FIG. 29.

FIG. 29 illustrates, as (a: before fitting and in middle of fitting), the positional relationship of one cam groove 62 and the corresponding columnar protrusion 57 in the non-fitted state illustrated in FIG. 12 to FIG. 16 and the halfway fitted state illustrated in FIG. 17 to FIG. 22. In the non-fitted state and the halfway fitted state, the heat sink 51 including the columnar protrusions 57 is pressed in the forward direction (in +Y direction) with force P1 by the first pressing means 63, and is pressed in the downward direction (in -Z direction) with force P2 by the second pressing means 64. In the present embodiment, the force P2 is zero or a slight value because of presence of the clearance grooves 58.

When the state is shifted from the state to the fitted state illustrated in FIG. 23 to FIG. 28, the positional relationship of each cam groove 62 and the corresponding columnar protrusion 57 is put into a state illustrated as (b: fitted state) in FIG. 29. Even in the fitted state, although the heat sink 51 is pressed in the forward direction (in +Y direction) with the force P1 by the first pressing means 63, the positions of the columnar protrusions 57 are defined by abutment of the plug abutting surface 25 and the heat sink abutting surface 55, and are stably maintained by engagement of the locking portion 24 and the locked portion 45. Further, in the state where the heat sink 51 is pressed in the downward direction (-Z direction) with the force P2 by the second pressing means 64, the positions of the columnar protrusions 57 are defined by abutment of the upper surface of the plug shell 21 and the heat releasing surface (heat conductive sheet 56) of the heat sink 51.

When the state is further shifted from the fitted state to the halfway fitted state and the non-fitted state, the state is shifted from the state illustrated as (b: fitted state) to the state illustrated as (a: before fitting and in middle of fitting) in FIG. 29. The state is realized when the user causes the locking portion 24 and the locked portion 45 to disengage from each other and extracts the plug connector 20 in the forward direction (in +Y direction). At this time, the first pressing means 63 presses the heat sink 51 in the forward direction (in +Y direction), and the columnar protrusions 57 of the heat sink 51 move in the forward direction (in +Y direction) inside the respective cam grooves 62. As a result, the heat sink 51 is lifted up to the halfway fitted state, and the heat conductive sheet 56 and the plug shell 21 are separated from each other in the Z direction (in up-down direction). When the columnar protrusions 57 move in the forward direction (in +Y direction) inside the respective cam grooves 62, the columnar protrusions 57 move along the substantially L-shaped groove shapes of the cam grooves 62. In each of the cam grooves 62 according to the present embodiment, a groove inner diameter of a right angle part bent in the substantially L-shape is expanded to form a guide shape 62a that smoothly guides movement of the corresponding columnar protrusion 57 in the cam groove 62. Therefore, when the state is shifted from the fitted state to the halfway fitted state and the non-fitted state, the heat sink 51 can smoothly return to the non-fitted initial state.

Further, in the present embodiment, to enable the columnar protrusions 57 to smoothly move inside the respective cam grooves 62 when the state is shifted from the fitted state to the halfway fitted state and the non-fitted state, the configuration is made to establish the following inequality,

$$P1 > P2,$$

where P1 is the pressing force of the first pressing means 63, and P2 is the force in the rearward direction (in -Y direction) that is the negative first direction by the pressing force of the second pressing means 64. When the configuration is made to satisfy such a condition, frictional force in the rearward direction (in -Y direction) acts on each of the portions during separation of the plug connector 20 with the force of the second pressing means 64, and the above-described series of operation can be smoothly performed.

In the electronic device 10 according to the present embodiment described above, when the plug connector 20 is inserted into the opening 42 of the receptacle housing 41 and the fitted state is established, the plug shell 21 and the heat releasing surface (heat conductive sheet 56) of the heat sink 51 come into contact with each other without rubbing each other, which enables the heat sink 51 to efficiently dissipate heat generated from the plug connector 20.

Although the preferred embodiment of the present invention is described above, the technical scope of the present invention is not limited to the scope described in the above-described embodiment. Various changes or improvements can be added to the above-described embodiment.

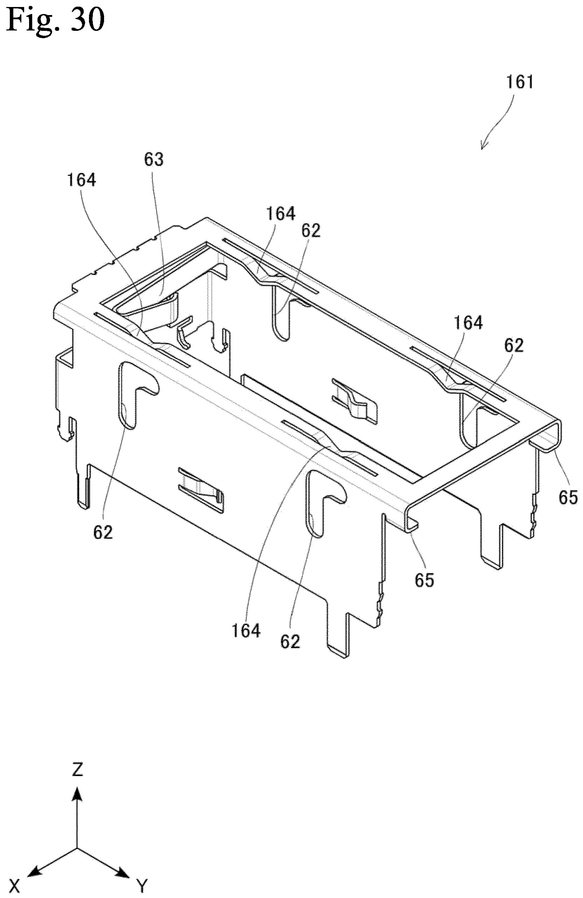

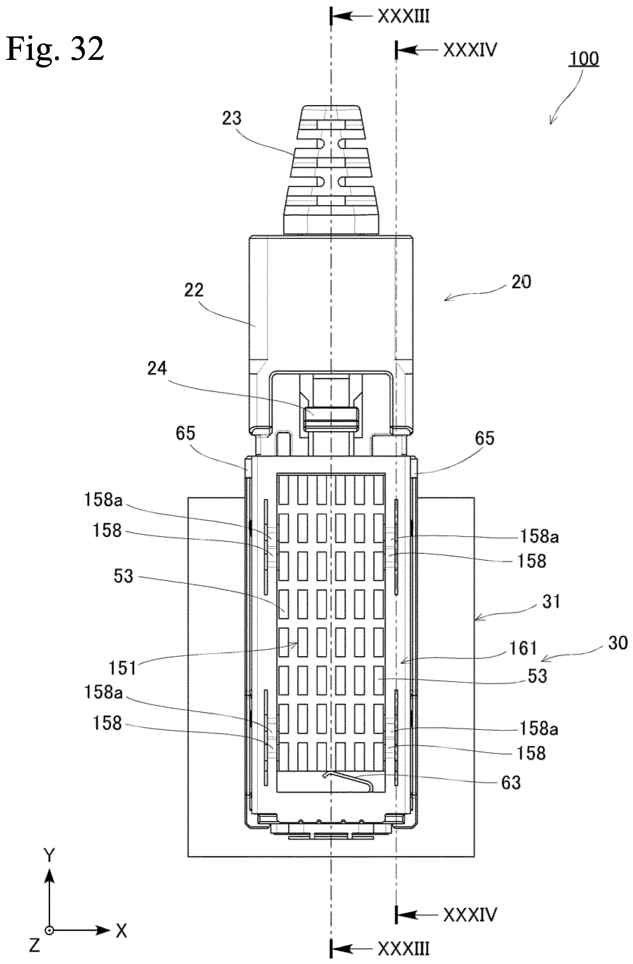

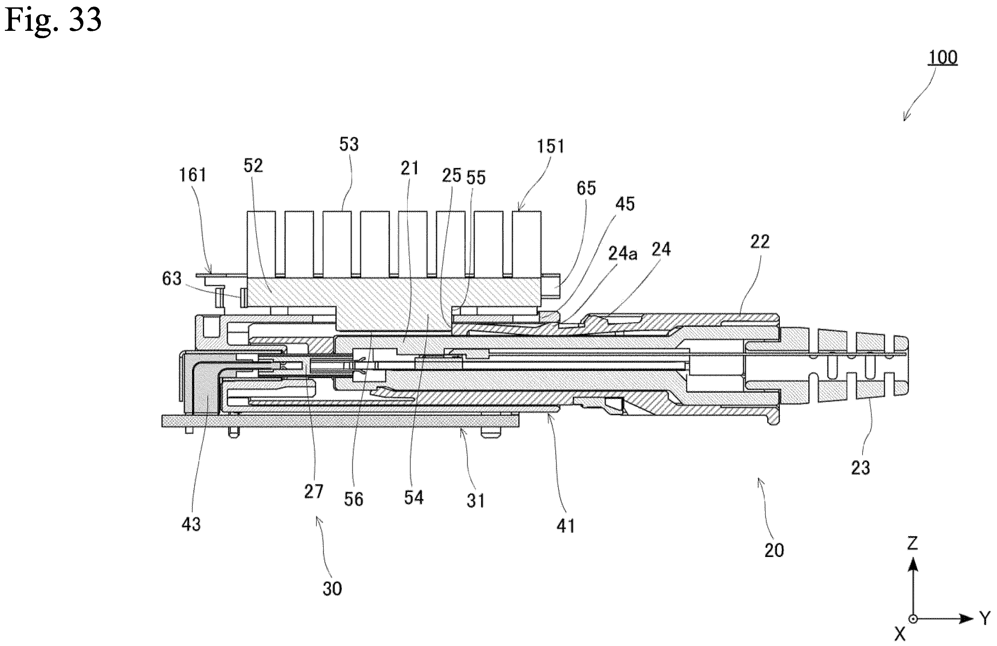

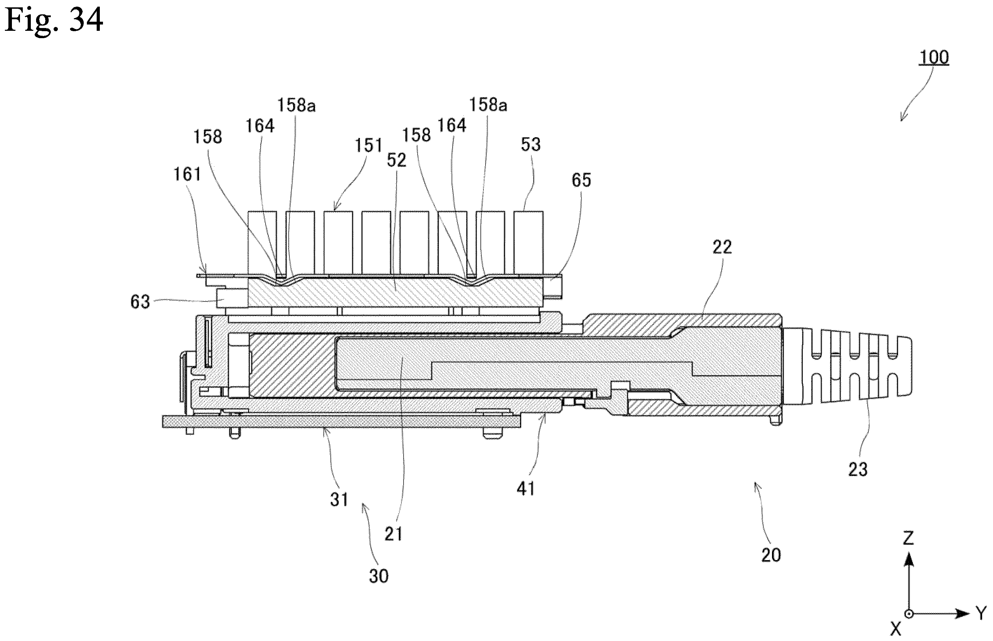

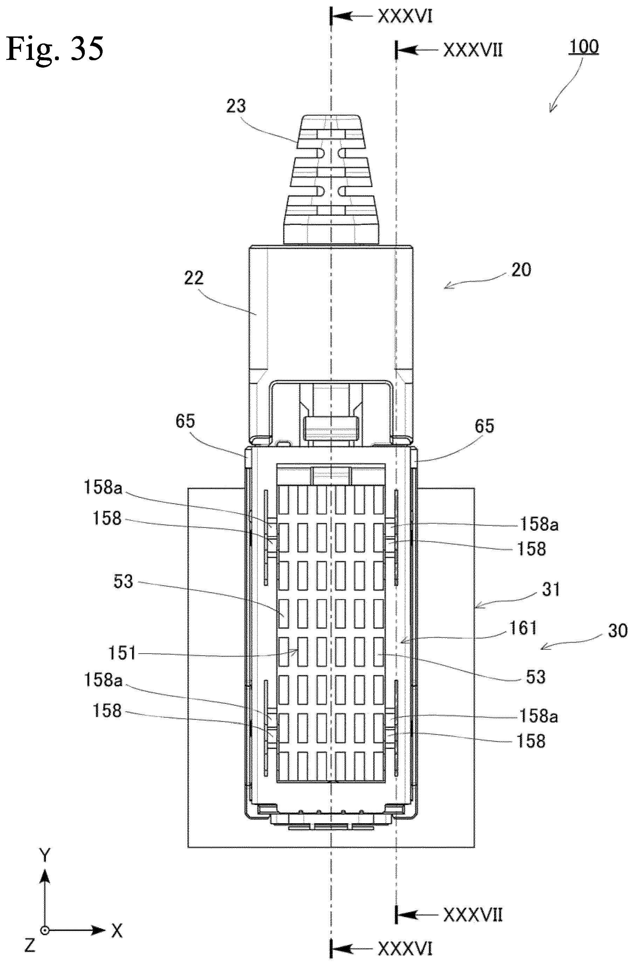

For example, in the above-described present embodiment, each of the first pressing means 63 and the second pressing means 64 is a cantilever spring having a cantilever shape formed on the receptacle shell 61. However, each of the first pressing means and the second pressing means according to the present invention can be formed as a double-end supported spring having a double-end supported beam shape. FIG. 30 to FIG. 37 illustrate a modification in a case where the second pressing means according to the present invention is formed as a double-end supported spring having a double-end supported beam shape. In an electronic device 100 according to the modification described with reference to FIG. 30 to FIG. 37, members same as or similar to the members according to the above-described embodiment are denoted by the same reference numerals, and description of the members is omitted.

As illustrated in FIG. 30, in a receptacle shell 161 according to the modification, second pressing means 164 pressing the heat sink 151 in the downward direction (in -Z direction) that is the negative second direction, relative to the receptacle shell 161 is formed as a double-end supported spring having a double-end supported beam shape. In such a modification, spring elastic force as pressing force is large as compared with the second pressing means 64 formed as the above-described cantilever spring according to the present embodiment. The configuration of the second pressing means 164 according to the modification is preferable because, for example, it is necessary to press the heat sink 151 by strong force in order to prevent the heat sink 151 from moving even when strong vibration shock is applied from the outside in the fitted state, and the load based on the spring elastic force applied by the second pressing means 164 is enhanced to a necessary load. However, as described in the present embodiment, to enable the columnar protrusions 57 to smoothly move inside the respective cam grooves 62 during the separation operation, it is necessary to establish the following inequality,

$$P1 > P2,$$

where P1 is the pressing force of the first pressing means 63, and P2 is the force in the rearward direction (in -Y direction) that is the negative first direction by the pressing force of the second pressing means 164. To simply realize such a configuration, the pressing force (load of spring elastic force) of the first pressing means 63 is required to be made greater than or equal to the pressing force of the second pressing means 164 (frictional force by contact of the columnar protrusions 57 with cam grooves 62). Thus, to resist strong vibration shock, the portion of the first pressing means 63 may become excessively large.

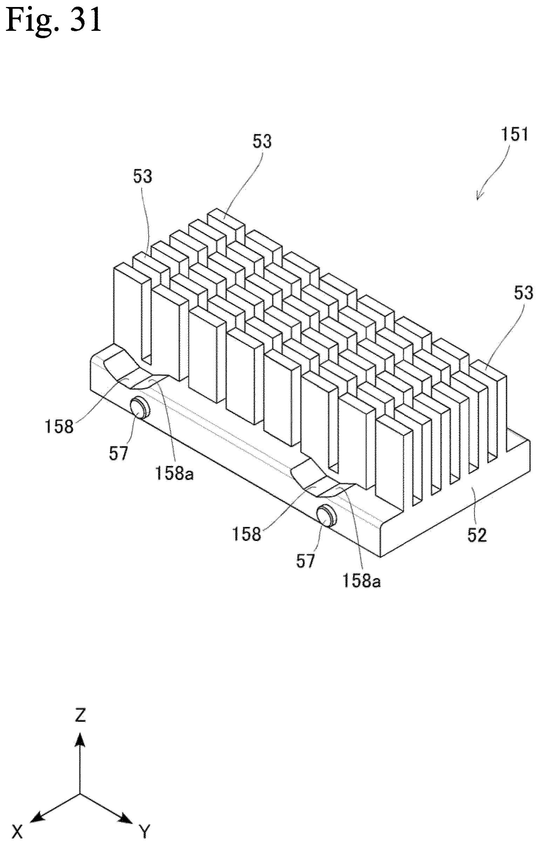

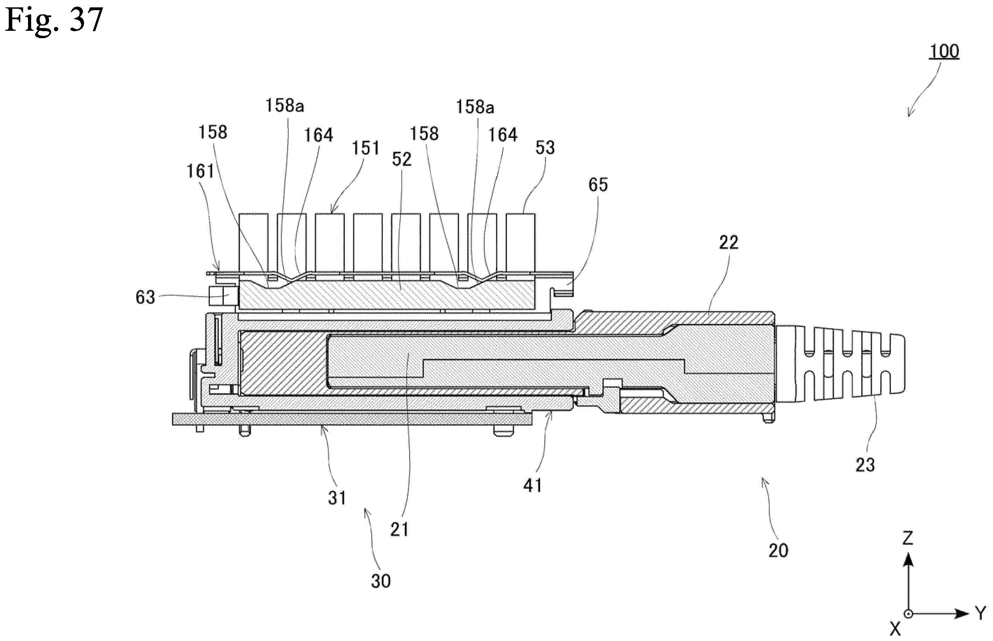

Therefore, in the modification, as illustrated in FIG. 31, formation ranges of four clearance grooves 158 provided at left and right positions on the front side and the rear side on the upper surface of the base portion 52 of the heat sink 151 are made wider than those in the above-described embodiment, and the second pressing means 164 are brought into contact with the middle of inclined surfaces 158a provided on the front sides of the clearance grooves 158 in the fitted state (see FIG. 37). In other words, as illustrated in FIG. 37, when the plug connector 20 is inserted into the opening 42 of the receptacle housing 41 and the fitted state is established, the surface of the heat sink 151 receiving the pressing force of the second pressing means 164 is formed as the inclined surfaces 158a that directs at least a part of load components of the pressing force toward the first direction (to Y direction). With such a configuration, the pressing force (load of spring elastic force) of the second pressing means 164 is inclined by action of the shapes of the inclined surfaces 158a. Thus, even in the case where the load of the pressing force (load of spring elastic force) of the second pressing means 164 is enhanced, it is unnecessary to increase the load of the pressing force (load of spring elastic force) of the first pressing means 63 more than necessary. This is because component force of the load based on a horizontal component of the pressing force (load of spring elastic force) of the second pressing means 164 is added to the load of the pressing force (load of spring elastic force) of the first pressing means 63. Such a configuration condition contributes to realization of the electronic device 100 according to the modification that can achieve action effects similar to the action effects of the electronic device 10 according to the above-described present embodiment.

For example, in the above-described embodiment and modification, the first pressing means 63 and the second pressing means 64 or 164 are configured as the members integrated with the receptacle shell 61 or 161. However, the first pressing means and the second pressing means according to the present invention can be configured as members separated from the receptacle shell. More specifically, the first pressing means and the second pressing means according to the present invention are formed as coil springs or plate springs separated from the receptacle shell 61 or 161, and are installed between the receptacle shell 61 or 161 and the heat sink 51 or 151. This makes it possible to realize an electronic device that can achieve action effects similar to the action effects by the above-described present embodiment and modification.

For example, in the above-described present embodiment, the configuration in the case where the heat conductive sheet 56 is installed on the heat releasing surface of the heat sink 51 abutting on the upper surface of the plug shell 21 is exemplified; however, installation of the heat conductive sheet 56 can be omitted in the electronic device according to the present invention.

For example, in the above-described embodiment, the form example in the case where the guide portions provided in the receptacle shell 61 are formed as the cam grooves 62 each having a groove shape, and the guided portions provided on the heat sink 51 are formed as the columnar protrusions 57 fitted to the groove shapes of the respective cam grooves 62 is illustrated. However, as the guide portions and the guided portions according to the present invention, all forms can be adopted as long as action effects similar to the action effects by the above-described embodiment can be achieved.

For example, in the above-described present embodiment and modification, the electronic devices 10 and 100 are described as optical transceivers; however, the form example is merely a possible form of the electronic device according to the present invention. The electronic device according to the present invention can be applied to all types of electronic devices as long as action effects similar to the action effects achieved by the above-described present embodiment and modification can be achieved.

It is also apparent from the claims that a form to which such changes or improvements are added can be included in the technical scope of the present invention.

Reference Signs List

10 electronic device (present embodiment)
20 plug connector
21 plug shell
22 plug housing
23 cable attachment portion
24 locking portion (fixing means)
24a claw
25 plug abutting surface (abutting surface)
26 plug opening
27 plug-side fitting terminal
30 receptacle connector
31 substrate
32 attachment hole
41 receptacle housing
42 opening
43 receptacle-side fitting terminal
44 upward open hole
45 locked portion (fixed means including horizontal wall surface and hole shape)
51 heat sink
52 base portion
53 fin-shaped portion
54 protruding portion
55 heat sink abutting surface (abutting surface)
56 heat conductive sheet
57 columnar protrusion (guided portion)
58 clearance groove
61 receptacle shell
62 cam groove (guide portion)
62a guide shape
63 first pressing means (cantilever spring having cantilever shape)
64 second pressing means (cantilever spring having cantilever shape)
65 stopper portion
100 electronic device (modification)
151 heat sink
158 clearance groove
158a inclined surface
161 receptacle shell
164 second pressing means (double-end supported spring having double-end supported beam shape)

**Claims**

1.  An electronic device (10, 100), comprising:

    a plug connector (20) including a plug shell (21) and a plug housing (22);
    a receptacle housing (41) including an opening (42) into/from which the plug connector (20) is insertable/extractable; and
a heat sink (51, 151) movably installed on the receptacle housing (41) by being installed through a receptacle shell (61, 161) attached to the receptacle housing (41), wherein
when the plug connector (20) is inserted into the opening (42) of the receptacle housing (41) and a fitted state is established, the plug shell (21) and a heat releasing surface of the heat sink (51, 151) come into contact with each other, and the heat sink (51, 151) dissipates heat generated from the plug connector (20),
when an insertion/extraction direction of the plug connector (20) into/from the opening (42) of the receptacle housing (41) is defined as a first direction, the extraction direction of the plug connector (20) from the opening (42) is defined as a positive first direction, the insertion direction is defined as a negative first direction, a direction orthogonal to the first direction is defined as a second direction, a direction in which the plug shell (21) and the heat releasing surface of the heat sink (51) are separated from each other is defined as a positive second direction, and a direction in which the plug shell (21) and the heat releasing surface of the heat sink (51, 151) come close to each other is defined as a negative second direction,
the heat sink (51, 151) is supported to be movable in the first direction and the second direction relative to the receptacle shell (61, 161),
first pressing means (63) configured to press the heat sink (51, 151) in the positive first direction relative to the receptacle shell (61, 161) and second pressing means (64, 164) configured to press the heat sink (51) in the negative second direction relative to the receptacle shell (61, 161) are disposed between the heat sink (51) and the receptacle shell (61, 161),
the receptacle shell (61, 161) includes a guide portion (62) configured to lift up the heat sink (51, 151) in the positive second direction when the heat sink (51, 151) is at a position in the positive first direction relative to the receptacle shell (61, 161), and to enable the heat sink (51, 151) to move in the negative second direction when the heat sink (51, 151) is at a position in the negative first direction relative to the receptacle shell (61, 161),
the heat sink (51, 151) includes a guided portion (57) configured to be guided by the guide portion (62) provided on the receptacle shell (61, 161), and
the heat sink (51, 151) and the plug connector (20) include respective abutting surfaces abutting on each other in the first direction when the plug connector (20) is inserted into the opening (42) of the receptacle housing (41).

**2.** The electronic device (10, 100) according to claim 1, wherein

the plug housing (22) includes a locking portion (24) serving as fixing means,

the receptacle housing (41) includes a locked portion (45) serving as fixed means, and

when the plug connector (20) is inserted into the opening (42) of the receptacle housing (41) and the fitted state is established, the locking portion (24) and the locked portion (45) engage with each other to maintain the fitted state of the plug connector (20) to the receptacle housing (41) against pressing force by the first pressing means (63).

**3.** The electronic device (10, 100) according to claim 1 or 2, wherein

a clearance groove (58, 158) for releasing pressing force from the second pressing means (64, 164) is provided at a portion of the heat sink (51, 151) receiving the pressing force from the second pressing means (64, 164),

in a state before the plug connector (20) is inserted into the opening (42) of the receptacle housing (41), the second pressing means (64, 164) is positioned at a formation position of the clearance groove to establish a state where all or part of the pressing force from the second pressing means (64, 164) is not applied to the heat sink (51), and

when the plug connector (20) is inserted into the opening (42) of the receptacle housing (41) and the fitted state is established, the position of the second pressing means (64, 164) is deviated from the formation position of the clearance groove to establish a state where all or part of the pressing force from the second pressing means (64, 164) is applied to the heat sink (51, 151).

**4.** The electronic device (100) according to any one of claims 1 to 3, wherein, when the plug connector (20) is inserted into the opening (42) of the receptacle housing (41) and the fitted state is established, a surface of the heat sink (151) receiving the pressing force from the second pressing means (164) is formed as an inclined surface (158a) directing at least a part of load components of the pressing force toward the first direction.

**5.** The electronic device (10, 100) according to any one of claims 1 to 4, wherein each of the first pressing means (63) and the second pressing means (64, 164) is formed as a cantilever spring having a cantilever shape or a double-end supported spring having a double-end supported beam shape.

**6.** The electronic device (10, 100) according to any one of claims 1 to 5, wherein an inequality of P1 > P2 is established, where P1 is pressing force of the first pressing means (63), and P2 is force in the negative first direction by pressing force of the second pressing means (64, 164).

**7.** The electronic device (10, 100) according to any one of claims 1 to 6, wherein a heat conductive sheet (56) is installed on the heat releasing surface of the heat sink (51, 151).

**8.** The electronic device (10, 100) according to any one of claims 1 to 7, wherein

the guide portion (62) is formed as a cam groove having a groove shape, and

the guide portion (62) has a substantially L-shaped groove shape.

**9.** The electronic device (10, 100) according to claim 8, wherein

the guided portion (57) is formed as a columnar protrusion to be fitted into the groove shape of the guide portion (62), and

the substantially L-shaped groove shape of the guide portion (62) includes a guide shape configured to guide motion of the guided portion (57) inside the groove, the guide shape being formed by expanding a groove inner diameter of a right angle part bent in the substantially L-shape.

**10.** The electronic device (10, 100) according to any one of claims 1 to 9, wherein the first pressing means (63) and the second pressing means (64, 164) are configured as members integrated with the receptacle shell (61, 161).

**11.** The electronic device (10, 100) according to any one of claims 1 to 9, wherein the first pressing means (63) and the second pressing means (64, 164) are configured as members separated from the receptacle shell (61, 161).

# Fig. 1

Fig. 2

EP 4 741 898 A1

# Fig. 3

Fig. 4

# Fig. 5

Fig. 6

Fig. 7

# Fig. 8

Fig. 9

# Fig. 10

Fig. 11

Fig. 12

Fig. 13

Fig. 14

EP 4 741 898 A1

Fig. 15

Fig. 16

Fig. 17

Fig. 18

Fig. 19

EP 4 741 898 A1

Fig. 20

Fig. 21

EP 4 741 898 A1

# Fig. 22

Fig. 23

Fig. 24

Fig. 25

Fig. 26

EP 4 741 898 A1

Fig. 27

EP 4 741 898 A1

Fig. 28

# Fig. 29a

DEFINED BY MOVING RANGE LIMIT
BY STOPPER PORTION 65

57   P1

62a

62

P2

DEFINED BY SHAPE OF CAM GROOVE 62

Z

X   Y

BEFORE FITTING AND IN MIDDLE OF FITTING

EP 4 741 898 A1

# Fig. 29b

DEFINED BY ABUTMENT OF PLUG ABUTTING
SURFACE 25 AND HEAT SINK ABUTTING
SURFACE 55

62a    57  P1

P2

62

DEFINED BY ABUTMENT OF UPPER SURFACE OF
PLUG SHELL 21 AND HEAT RELEASING SURFACE
(HEAT CONDUCTIVE SHEET 56) OF HEAT SINK 51

Z

X ⊙——▶ Y

FITTED STATE

EP 4 741 898 A1

# Fig. 30

# Fig. 31

Fig. 32

Fig. 33

EP 4 741 898 A1

Fig. 34

EP 4 741 898 A1

Fig. 35

EP 4 741 898 A1

Fig. 36

Fig. 37

Fig. 38

(A)

(B)

Fig. 39

(A)

(B)

(C)

(D)

(E)

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 219 876 711 U (INNOLIGHT TECHNOLOGY CORP) 20 October 2023 (2023-10-20) * paragraphs [0049], [0054], [0057], [0059] - [0065], [0086], [0094]; figures 1-3,5,9,10 * | 1-11 | INV. G02B6/42 G06F1/20 H05K7/20 |
| A | US 11 789 220 B1 (NGUYEN TRI [US] ET AL) 17 October 2023 (2023-10-17) * column 4, lines 17-24 * * column 5, lines 23-38 * * column 6, lines 40-50 * * figures 3,4(c) * | 2,11 | |
| A | US 2009/296350 A1 (OKI KAZUSHIGE [JP] ET AL) 3 December 2009 (2009-12-03) * paragraph [0027]; figure 2A * | 7 | |
| A | US 10 212 852 B1 (REDDY ANUYA [IN] ET AL) 19 February 2019 (2019-02-19) * figures 3-6 * | 8,9 | |

**TECHNICAL FIELDS SEARCHED (IPC)**

G02B
H05K
G06F

The present search report has been drawn up for all claims

| Place of search | Date of completion of the search | Examiner |
|---|---|---|
| The Hague | 25 February 2026 | Pantelakis, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 19 9784

This annex lists the patent family members relating to the patent documents cited in the above-mentioned European search report.
The members are as contained in the European Patent Office EDP file on
The European Patent Office is in no way liable for these particulars which are merely given for the purpose of information.

25-02-2026

| Patent document cited in search report | | Publication date | Patent family member(s) | | Publication date |
|---|---|---|---|---|---|
| CN 219876711 | U | 20-10-2023 | CN | 219876711 U | 20-10-2023 |
| | | | WO | 2024234744 A1 | 21-11-2024 |
| US 11789220 | B1 | 17-10-2023 | NONE | | |
| US 2009296350 | A1 | 03-12-2009 | JP | 4998249 B2 | 15-08-2012 |
| | | | JP | 2009152427 A | 09-07-2009 |
| | | | US | 2009296350 A1 | 03-12-2009 |
| US 10212852 | B1 | 19-02-2019 | NONE | | |

EPO FORM P0459

For more details about this annex : see Official Journal of the European Patent Office, No. 12/82

**EP 4 741 898 A1**

**REFERENCES CITED IN THE DESCRIPTION**

**Patent documents cited in the description**

- JP 2009152428 A